# EUROPEAN PATENT SPECIFICATION

(11) **EP 2 757 417 B1**
(45) Date of publication and mention of the grant of the patent: **25.05.2016**
(21) Application number: 12832408.4
(22) Date of filing: 14.09.2012
(51) Int. Cl.: G03F 7/30, G03F 7/32, B01D 1/00, C02F 1/04, G03F 7/00

(54) **METHOD FOR RECYCLING WASTEWATER PRODUCED BY PLATE-MAKING PROCESS**
VERFAHREN ZUR WIEDERVERWERTUNG VON ABWASSER DURCH EIN PLATTENHERSTELLUNGSVERFAHREN
PROCÉDÉ DE RECYCLAGE D'EAUX USÉES PRODUITES PAR UN PROCÉDÉ DE FABRICATION DE PLAQUE

(30) Priority: 15.09.2011 JP 2011201890
(43) Date of publication of application: 23.07.2014
(73) Proprietor: FUJIFILM Corporation, Tokyo 106-8620 (JP)
(72) Inventor: KOBAYASHI, Fumikazu, Haibara-gun Shizuoka 421-0396 (JP); WATANABE, Toshihiro, Haibara-gun Shizuoka 421-0396 (JP); AOSHIMA, Norio, Haibara-gun Shizuoka 421-0396 (JP)
(74) Representative: Hoffmann Eitle
(86) International application number: PCT/JP2012/073737
(87) International publication number: WO 2013/039235

(56) References cited:
- WO-A1-2011/036923
- WO-A1-2011/037080
- JP-A- H0 534 870
- JP-A- H01 307 755
- JP-A- H07 234 524
- JP-A- H08 117 735
- JP-A- 2004 070 031
- JP-A- 2011 090 282

## Description

### Technical Field

The present invention relates to a method of recycling waste liquid produced by a plate-making process performed on a photosensitive planographic printing plate. The present invention particularly relates to a method of recycling plate-making process waste liquid, the method including replenishing a development replenisher liquid that includes an organic solvent, concentrating the plate-making process waste liquid, and reutilizing the obtained regenerated water.

### Background Art

From the past, in the case of a development of a photosensitive planographic printing plate using an automatic developing machine, a method whereby a development replenisher liquid is supplied to developer liquids in respective processes is employed in order to maintain constant the concentrations of components that are decreased by the processes or passage of time, thereby maintaining the power of the developer liquid. In a case in which the power of the developer liquid becomes outside the tolerable range even with this type of replenishment, the entire developer liquid is disposed of. Since the plate-making process waste liquid is strongly alkaline, it is practically impossible to discharge the waste liquid as it is to sewers in consideration of the environmental pollution control which has been strengthened in recent years. Therefore, plate-making companies have to process the waste liquid by, for example, installing waste liquid processing facilities by themselves, or entrusting the processing of the waste liquid to waste liquid processing companies.

However, with the method of entrusting waste liquid processing companies, a huge space is required for the storage of the waste liquid until the waste liquid is transferred, and, also, the method is quite expensive from the viewpoint of costs. Furthermore, the installation of waste liquid processing facilities has problems in that quite large initial investment is required for the installation, and in that quite a large space is required for the preparation for the installment.

In order to address these problems, for example, a method of concentrating the waste liquid by blowing warm air to a waste liquid storage tank is proposed in Japanese Patent Application Laid-Open (JP-A) No. H05-341535, and a technology of aggregating aggregative components by neutralizing the waste liquid produced by a process and adding an aggregating agent is proposed in JP-A No. H02-157084.

In the technology disclosed in JP-A No. H05-341535, the evaporation amount is not large, and, therefore, it takes a long time to concentrate the plate-making process waste liquid. Accordingly, the effect in terms of reducing the amount of waste liquid is not sufficient. Further, the processing of evaporated moisture has not been considered.

The technology disclosed in JP-A No. H02-157084 has a problem in that costs are incurred for processing the waste liquid due to the necessity of an aggregating agent. Furthermore, in the case of plate-making process waste liquid that includes polymers, there has been a problem in that drop-like solids remaining inside an evaporation pot adhere to the wall surfaces of the evaporation pot and makes the wall surfaces dirty, and in that the pipes in the waste liquid processing apparatus is likely to be clogged.

Furthermore, an apparatus for reducing waste liquid produced by a planographic printing plate-making process has been proposed, the apparatus being capable of decreasing the discharge amount of the plate-making process waste liquid and capable of easily reutilizing water generated in the course of the processing of the plate-making process waste liquid (see, for example, Japanese Patent No. 4774124).

From the viewpoint of dealing with the problem of the waste liquid produced by a development process of a planographic printing plate based on the formulation of a developer liquid for a planographic printing plate, a developer liquid containing a non-reducing sugar and a base has been proposed (see, for example, JP-A No. 2011-90282).

To sufficiently separate solid content and liquid JP-A No. H05-34870 discloses a volume reduction of the development waste liquid by evaporation of water in a range from 2 to 30 times, and preferably from 5 to 20 times.

In WO 2011/036923 a method of processing waste development solution and recovering water is disclosed; concentrating the waste liquid by evaporation, also under reduced pressure, in the range of 1/5 to 1/8 is disclosed.

### SUMMARY OF INVENTION

### Technical Problem

An object of the present invention is to provide a method of recycling plate-making process waste liquid, with which the generation of dirt caused by accumulation of deposited matter in a development bath, a water-washing bath or the like of an automatic developing machine is suppressed, and with which the maintainability of facilities is excellent, and with which the generation of a precipitate is suppressed even in a case in which a plate-making process is performed continuously for a long time, and with which cleaning can be easily performed, and with which regenerated water obtained can be reutilized, and with which the amount of waste liquid disposed of as plate-making process waste liquid is very small. Solution to Problem

The invention includes the following aspects.
<1> A method of recycling waste liquid from a plate-making process for a photosensitive planographic printing plate that is discharged by a plate-making process for a photosensitive planographic printing plate using a developer liquid for a photosensitive planographic printing plate in an automatic developing machine, the method including:
   replenishing a development bath of the automatic developing machine with a development replenisher liquid without dilution or after dilution of the development replenisher liquid with an amount of water no more than 10 times the amount of the development replenisher liquid in terms of mass, the development replenisher liquid including an organic solvent having a boiling point in the range of from 100°C to 300°C, and a content ratio of organic solvent having a boiling point in the range of from 100°C to 300°C in the development replenisher liquid being in the range of from 5% by mass to 30% by mass;
   concentrating plate-making process waste liquid, which has been generated during a plate-making process for a photosensitive planographic printing plate in the automatic developing machine, by evaporation using an evaporation concentration apparatus such that the ratio of the amount of the plate-making process waste liquid after the concentrating, to the amount of the plate-making process waste liquid before the concentrating, is in the range of from 1/2.5 to 1/5 in terms of volume, thereby separating the plate-making process waste liquid into water vapor and dissolved components;
   recovering the separated water vapor from the evaporation concentration apparatus and condensing the water vapor in a cooling means to obtain regenerated water; and
   using the obtained regenerated water as at least one of diluent water for the development replenisher liquid or rinsing water in the automatic developing machine.
<2> The method of recycling plate-making process waste liquid according to <1>, wherein the development replenisher liquid further includes a surfactant, a content ratio of surfactant in the development replenisher liquid being in the range of from 0.5% by mass to 10% by mass.
<3> The method of recycling plate-making process waste liquid according to <2>, wherein the surfactant includes at least one anionic surfactant selected from the group consisting of a compound represented by the following Formula (I-A) and a compound represented by the following Formula (I-B): 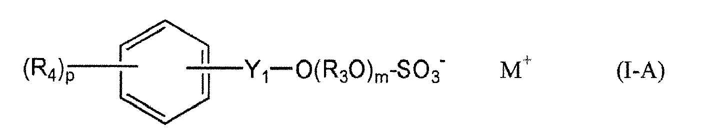 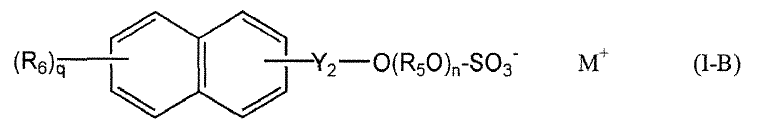 wherein, in Formula (I-A), R₃ represents a straight-chain or branched-chain alkylene group having from 1 to 5 carbon atoms; R₄ represents a straight-chain or branched-chain alkyl group having from 1 to 20 carbon atoms; p represents 0, 1 or 2; Y₁ represents a single bond or an alkylene group having from 1 to 10 carbon atoms; m represents an integer from 1 to 100; when m is 2 or greater, plural R₃'s are present, and the plural R₃'s may be the same as or different from each other; and M⁺ represents Na⁺, K⁺, Li⁺ or NH₄⁺; and
   wherein, in Formula (I-B), R₅ represents a straight-chain or branched-chain alkylene group having from 1 to 5 carbon atoms; R₆ represents a straight-chain or branched-chain alkyl group having from 1 to 20 carbon atoms; q represents 0, 1 or 2; Y₂ represents a single bond or an alkylene group having from 1 to 10 carbon atoms; n represents an integer from 1 to 100; when n is 2 or greater, plural R₅'s are present, and the plural R₅'s may be the same as or different from each other; and M⁺ represents Na⁺, K⁺, Li⁺ or NH₄⁺.
<4> The method of recycling plate-making process waste liquid according to <2>, wherein the surfactant includes at least one nonionic surfactant selected from the group consisting of a compound represented by the following Formula (II-A) and a compound represented by the following Formula (II-B): 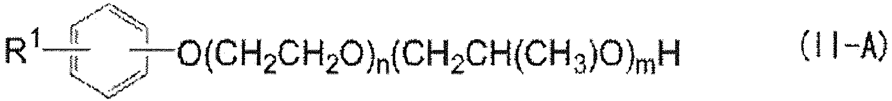 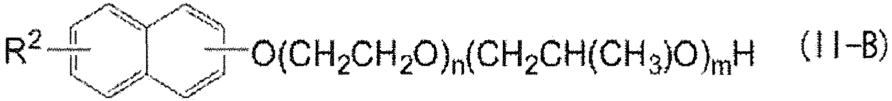 wherein, in Formula (II-A), R¹ represents a hydrogen atom or an alkyl group having from 1 to 100 carbon atoms; each of n and m independently represents an integer from 0 to 100; and n and m are not simultaneously 0; and
   wherein, in Formula (II-B), R² represents a hydrogen atom or an alkyl group having from 1 to 100 carbon atoms; each of n and m independently represents an integer from 0 to 100; and n and m are not simultaneously 0.
<5> The method of recycling plate-making process waste liquid according to any one of <1> to <4>, wherein the evaporation concentration apparatus includes a heating means and a pressure reducing means for reducing pressure inside the evaporation concentration apparatus, and the evaporation concentration apparatus heats the plate-making process waste liquid while performing pressure reduction.
<6> The method of recycling plate-making process waste liquid according to <5>, wherein the heating means includes a heat pump, heats the plate-making process waste liquid to generate water vapor at a heat release part of the heat pump, and cools the water vapor at a heat absorbing part of the heat pump.
<7> The method of recycling plate-making process waste liquid according to any one of <1> to <6>, further including recovering concentrated matter from the plate-making process waste liquid, which has been concentrated by evaporation, into a recovery tank through application of a pressure using a pump.
<8> The method of recycling plate-making process waste liquid according to any one of <1> to <7>, wherein the ratio of the amount of the plate-making process waste liquid after the concentrating, to the amount of the plate-making process waste liquid before the concentrating, is in the range of from 1/3 to 1/5 in terms of volume.
<9> The method of recycling plate-making process waste liquid according to any one of <1> to <8>, wherein the content ratio of the organic solvent having a boiling point in the range of from 100°C to 300°C in the development replenisher liquid is in the range of from 5% by mass to 20% by mass.
<10> The method of recycling plate-making process waste liquid according to any one of <1> to <9>, wherein the organic solvent having a boiling point in the range of from 100°C to 300°C includes an organic solvent selected from the group consisting of 2-phenylethanol, 3-phenyl-1-propanol, 2-phenoxyethanol, benzyl alcohol, cyclohexanol, monoethanolamine, diethanolamine, cyclohexanone, ethyl lactate, propylene glycol, ethylene glycol, γ-butyrolactone, N-methylpyrrolidone, N-ethylpyrrolidone, propylene glycol monomethyl ether, ethylene glycol monomethyl ether, ethylene glycol monomethyl ether acetate, diethylene glycol dimethyl ether, and glycerin.
<11> The method of recycling plate-making process waste liquid according to any one of <1> to <10>, wherein the organic solvent having a boiling point in the range of from 100°C to 300°C includes an organic solvent selected from the group consisting of benzyl alcohol, diethanolamine, monoethanolamine, γ-butyrolactone, N-methylpyrrolidone, and N-ethylpyrrolidone.
<12> The method of recycling plate-making process waste liquid according to any one of <1> to <11>, further including performing one or more selected from (i) analyzing components of the regenerated water and neutralizing the regenerated water based on a result of the analysis, or (ii) supplying fresh water to the regenerated water.
<13> The method of recycling plate-making process waste liquid according to any one of <1> to <12>, wherein the photosensitive planographic printing plate is a negative planographic printing plate.
<14> The method of recycling plate-making process waste liquid according to <13>, wherein the developer liquid for a photosensitive planographic printing plate used for the negative planographic printing plate is an alkali developer liquid that includes a surfactant and a hydroxide of an alkali metal but does not include a silicate compound, and that has a pH in the range of from 10 to 12.5.
<15> The method of recycling plate-making process waste liquid according to any one of <1> to <12>, wherein the photosensitive planographic printing plate is a positive planographic printing plate.
<16> The method of recycling plate-making process waste liquid according to <15>, wherein the developer liquid for a photosensitive planographic printing plate used for the positive planographic printing plate is an alkali developer liquid that includes an organic compound having a buffering action and a base, and that does not include a silicate compound.

The method of recycling plate-making process waste liquid according to the invention is a method of recycling plate-making process waste liquid discharged from a development process system of an automatic developing machine. In the method of recycling plate-making process waste liquid according to the invention, a development replenisher liquid that includes an organic solvent having a boiling point in the range of from 100°C to 300°C and in which the content ratio of organic solvent having a boiling point in the range of from 100°C to 300°C is in the range of from 5% by mass to 30% by mass is used as a development replenisher liquid, and the plate-making process waste liquid generated is concentrated by evaporation to a degree of concentration in the range of from 1/2.5 to 1/5 in terms of volume. In other words, in the present invention, plate-making process waste liquid discharged during a plate-making process for a photosensitive planographic printing plate is heated and concentrated by evaporation in an evaporation concentration apparatus (for example, an evaporation concentration apparatus that includes a concentration pot), and separated into water vapor and dissolved components; the separated water vapor is cooled to obtain regenerated water, and the regenerated water obtained can be reutilized. Therefore, a method of recycling plate-making process waste liquid with which dirt caused by accumulation of deposited matter on the development bath, water-washing bath or the like of an automatic developing machine in a development process system is decreased, and with which cleaning can easily be performed, and with which the amount of waste liquid to be disposed of as plate-making process waste liquid is quite small, can be provided.

Although the mechanism of the action in the invention is not clearly understood, it is presumed that, in the invention, since the development replenisher liquid includes a specific amount of organic solvent having a boiling point in the range of from 100°C to 300°C and the boiling point of the organic solvent contained in the development replenisher liquid and the boiling point of water are largely different from each other, evaporation of water contained in the plate-making process waste liquid is relatively easy, and regenerated water that includes water as a main component can easily be obtained. Furthermore, it is presumed that: photosensitive components and the like that have been removed from a planographic printing plate by development dissolve in the organic solvent, which is present at a relatively high concentration in the plate-making process waste liquid after the concentrating, and therefore the photosensitive components and the like are unlikely to become a residue of undissolved matter in the plate-making process waste liquid after the concentrating; as a result, solidification and adhesion in the inside of the evaporation concentration apparatus hardly occurs.

### Advantageous Effects of Invention

According to the invention, a method of recycling plate-making process waste liquid, with which the generation of dirt caused by accumulation of deposited matter in a development bath, a water-washing bath or the like of an automatic developing machine is suppressed, and with which the maintainability of facilities is excellent, and with which cleaning can be easily performed, and with which the generation of a precipitate is suppressed even in a case in which a plate-making process is performed continuously for a long time, and with which regenerated water obtained can be reutilized, and with which the amount of waste liquid disposed of as plate-making process waste liquid is very small, can be provided.

### BRIEF DESCRIPTION OF DRAWING

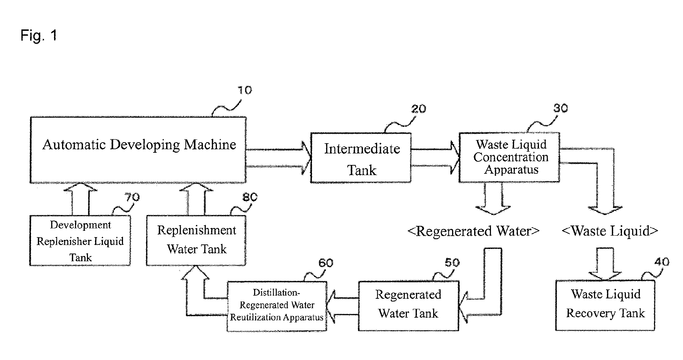

Fig. 1 is a conceptual diagram illustrating a flow of apparatuses according to a method of recycling plate-making process waste liquid according to the invention.

### DESCRIPTION OF EMBODIMENTS

The recycling method according to the invention is described below in detail.

The method of recycling waste liquid from a plate-making process for a photosensitive planographic printing plate according to the invention is a method of recycling waste liquid from a plate-making process for a photosensitive planographic printing plate that is discharged during a plate-making process for a photosensitive planographic printing plate using a developer liquid for a photosensitive planographic printing plate in an automatic developing machine, and the method includes:
replenishing a development bath of the automatic developing machine with a development replenisher liquid without dilution or after dilution of the development replenisher liquid with an amount of water no more than 10 times the amount of the development replenisher liquid in terms of mass, the development replenisher liquid including an organic solvent having a boiling point in the range of from 100°C to 300°C, and a content ratio of organic solvent having a boiling point in the range of from 100°C to 300°C in the development replenisher liquid being in the range of from 5% by mass to 30% by mass;
concentrating plate-making process waste liquid, which has been generated during a plate-making process for a photosensitive planographic printing plate in the automatic developing machine, by evaporation using an evaporation concentration apparatus such that the ratio of the amount of the plate-making process waste liquid after the concentrating, to the amount of the plate-making process waste liquid before the concentrating, is in the range of from 1/2.5 to 1/5 in terms of volume, thereby separating the plate-making process waste liquid into water vapor and dissolved components;
recovering the separated water vapor from the evaporation concentration apparatus and condensing the water vapor in a cooling means to obtain regenerated water; and
using the obtained regenerated water as at least one of diluent water for the development replenisher liquid or rinsing water in the automatic developing machine.

In one exemplary embodiment, the method according to the invention is a method of recycling plate-making process waste liquid that includes concentrating, by evaporation using an evaporation concentration apparatus, plate-making process waste liquid that is discharged during a plate-making process for a photosensitive planographic printing plate using a developer liquid for a photosensitive planographic printing plate in an automatic developing machine, so as to separate the plate-making process waste liquid into water vapor and dissolved components, and recovering the separated water vapor from the evaporation concentration apparatus and condensing the water vapor in a cooling means so as to obtain regenerated water, the method including:
replenishing a development bath of the automatic developing machine with a development replenisher liquid that includes an organic solvent having a boiling point in the range of from 100°C to 300°C, a content ratio of organic solvent having a boiling point in the range of from 100°C to 300°C in the development replenisher liquid being in the range of from 5% by mass to 30% by mass;
concentrating a generated plate-making process waste liquid to a degree of concentration in the range of from 1/2.5 to 1/5 (= plate-making process waste liquid after the concentrating / plate-making process waste liquid before the concentrating) in terms of volume, and using the regenerated water generated by the concentrating as at least one of diluent water for the development replenisher liquid or rinsing water in the automatic developing machine.

An exemplary embodiment according to the invention is described below with reference to the drawing.

In a method of recycling a development process waste liquid according to an exemplary embodiment, as illustrated in Fig. 1, a waste liquid of a developer liquid that is discharged from an automatic developing machine 10 due to a plate-making process for a photosensitive planographic printing plate is stored in an intermediate tank 20, and the waste liquid sent from the intermediate tank 20 is heated under reduced pressure by a waste liquid concentration apparatus 30, thereby separating the waste liquid into evaporated moisture and remaining concentrated matter (slurry). Regenerated water obtained by cooling and condensing the moisture that has been separated as water vapor in the waste liquid concentration apparatus 30 is introduced into a regeneration water tank 50. The waste liquid concentrated in the waste liquid concentration apparatus 30 is recovered in a waste liquid tank 40. The transfer of the waste liquid that has been concentrated in the waste liquid tank 40 is preferably carried out by applying pressure using a pump.

In the present invention, as described above, a development replenisher liquid which includes an organic solvent having a boiling point in the range of from 100°C to 300°C and in which the amount of organic solvent having a boiling point in the range of from 100°C to 300°C is in the range of from 5% by mass to 30% by mass is used in the present system, whereby the concentrating by evaporation of the plate-making process waste liquid generated during a plate-making processing of a photosensitive planographic printing plate, and the production of regenerated water, are performed efficiently, and the generation of dirt in the evaporation concentration apparatus is suppressed.

The evaporation concentration apparatus 30 that concentrates a waste liquid includes at least: an evaporation pot (not shown in the figure) that heats the waste liquid, which has been sent from the intermediate tank 20, under reduced pressure so as to separate the waste liquid into evaporated moisture and residual concentrated matter (slurry); and a cooling pot (not shown in the figure) into which the moisture, which has been separated as water vapor in the evaporation pot, is introduced and which cools and condenses the moisture to obtain regenerated water.

It is preferable that the evaporation concentration apparatus 30 is provided with a heat pump unit that transfers heat between the interior of the evaporation pot and the interior of the cooling pot. That is, it is preferable that a heat pump is used as a heating means of the evaporation pot and as a cooling means of the cooling pot, and that the plate-making process waste liquid is heated by a heat release part of the heat pump while water vapor in the cooling pot is cooled by a heat absorbing part of the heat pump.

It is preferable that the concentrating of the waste liquid is performed by a method including heating and concentrating the waste liquid while reducing pressure inside the evaporation pot using a pressure reducing means. This is because this method decreases the boiling point of the waste liquid and enables the waste liquid to be concentrated by evaporation at a temperature lower than that under atmospheric pressure. Therefore, it is preferable that the evaporation concentration apparatus 30 includes a pressure reducing means in addition to a heating means. Since the use of the pressure reducing means enables the concentrating by evaporation to be carried out with higher safety at a lower temperature, there is an advantage in that the evaporation pot, the waste liquid and waste liquid concentrated matter are less likely to be affected by heat. Examples of pressure reducing means that can be used in the evaporation concentration apparatus 30 include: general mechanical vacuum pumps such as a water seal vacuum pump, an oil rotation vacuum pump, and a diaphragm vacuum pump; diffusion pumps utilizing oil or mercury; compressors such as a multistage turbo compressor, a reciprocal compressor and a screw compressor; and an aspirator. Among these, an aspirator is preferable from the viewpoints of maintainability and cost.

In regard to the pressure reduction conditions, for example, the pressure may be reduced so as to adjust the pressure to 100 mmHg or lower, and preferably 30 mmHg or lower.

As described above, it is also a preferable embodiment to use a heat pump as a heating means in the evaporation pot and a cooling means in the cooling pot. In this embodiment, it is possible to heat the plate-making process waste liquid at the heat release part of the heat pump while cooling the vapor inside the cooling pot at the heat absorbing part of the heat pump. In the concentrating using this heat pump, since the concentrating by heating of the waste liquid is carried out by heat generation by the heat pump and the condensation of water vapor is carried out by heat absorption by the heat pump, the thermal efficiency thereof is high; there are advantages in that local increase of temperature is avoided, and that higher safety is provided, and that carbon dioxide emission is decreased, as compared to the case of using a heating means such as an electric heater, .

In regard to the heating conditions, a temperature range corresponding to a pressure of 5 mmHg to 100 mmHg, which can be easily achieved using a water-jet pump or a vacuum pump, is selected. Specifically, the heating temperature is, for example, in the range of from 20°C to 80°C, and more preferably in the range of from 25°C to 45°C.

Although it is also possible to perform the concentrating by distilling at a high temperature without reducing pressure, more electric power is required in this case. The heating temperature can be lowered, and the electric power usage can be regulated, by performing the concentrating under reduced pressure as described above.

In the process of concentrating the plate-making process waste liquid by evaporation in this evaporation concentration apparatus, the plate-making process waste liquid is heated by a heating means in the evaporation pot, and concentrated by evaporation such that the degree of concentration in terms of volume (volume after the concentrating / volume before the concentrating) becomes 1/2.5 to 1/5. Here, the amount of waste liquid to be processed is more effectively decreased since the degree of concentration is 1/(2.5 or more). Further, occurrence of precipitation of a solid in the waste liquid that has been concentrated inside the evaporation pot of the evaporation concentration apparatus 30 is suppressed since the degree of concentration is 1/(5 or less), as a result of which maintainability is improved.

In the method of recycling a development process waste liquid according to the present exemplary embodiment, a regenerated water tank 50 that temporarily stores the separated regenerated water, and a distillation-regenerated water reutilization apparatus 60 that controls the supply of the regenerated water to the automatic developing machine 10 are further employed. The distillation-regenerated water reutilization apparatus 60 is preferably connected, via piping, to a replenishment water tank 80 for supplying the regenerated water to the automatic developing machine 10. The piping that connects the replenishment water tank 80 and the development bath of the automatic developing machine 10 is preferably provided with a pressure gauge for measuring pressure inside the piping, and a pump.

The distillation-regenerated water reutilization apparatus 60 may include an analytic apparatus that analyzes the components of the regenerated water. The components of the regenerated water may be analyzed by the analytic apparatus, and the distillation-regenerated water reutilization apparatus 60 may be equipped with various means for formulating the composition of the regenerated water by performing a process such as the adjustment of pH by neutralization of the regenerated water in accordance with the components, or supply of fresh water to the regenerated water.

Driving of the pump is controlled in accordance with the value of the pressure measured with a pressure gauge included in the distillation-regenerated water reutilization apparatus 60, and the recovered regenerated water is supplied, in a predetermined amount and at a predetermined pressure, from the replenishment water tank 80 to the automatic developing apparatus 10 due to the driving of the pump. Further, a development replenisher liquid is supplied from a development replenisher liquid tank 70 to the automatic developing machine 10.

Since the regenerated water obtained by this system includes the organic solvent described above, the regenerated water has a composition that is suitable for use as diluent water for the development replenisher liquid of the automatic developing apparatus, or as rinsing water. Therefore, even when the regenerated water as it is is hardly suitable for discharge to general drainage in usual cases, the regenerated water can suitably be recycled in the present system.

Here, the term "rinsing water" refers to water that is used in order to wash a planographic printing plate after a development process or after a neutralization process performed subsequently to development, and tin order o remove respective treatment liquids remaining on a surface of the planographic printing plate.

In the present exemplary embodiment, the development replenisher liquid is diluted and supplied to the development bath of the automatic developing machine 10. In the system illustrated in Fig. 1, an embodiment may be adopted in which the development replenisher liquid is diluted at a predetermined ratio in the development bath (not shown in the figure) disposed inside the automatic developing machine 10, with the amount of the regenerated water supplied from the replenishment water tank 80 being controlled in accordance with the amount of the development replenisher liquid supplied from the development replenisher liquid tank 70. However, the invention is not limited to this embodiment, and the development replenisher liquid and the regenerated water may be mixed so as to dilute the development replenisher liquid at a predetermined ratio, and then the diluted development replenisher liquid may be supplied into the development bath. Depending on the composition of the development replenisher liquid, it is also possible to supply the development replenisher liquid as it is to the development bath, without dilution.

### <Development Replenisher Liquid>

The development replenisher liquid in the present specification is described below.

The developer liquid initially charged into the development bath of the automatic developing machine 10 is deteriorated due to matter that has separated from the developer liquid and that is generated by processing of photosensitive planographic printing plates. Since the developer liquid is alkaline, the pH of the developer liquid is decreased due to the absorption of carbon dioxide in air, whereby the developer liquid is deteriorated. Therefore, in order to perform development continuously for a long time in the automatic developing machine 10, it is usually necessary to intermittently or continuously supply the development replenisher liquid that compensates for the deterioration, in order to maintain the development quality of the photosensitive planographic printing plates.

Unless particularly specified otherwise, the term "developer liquid" in the present specification means an untreated developer liquid, and the term "development replenisher liquid" means a replenisher liquid for development that is supplied to the developer liquid in the development bath, the developer liquid in the development bath having been deteriorated as a result of development of photosensitive planographic printing plates, absorption of carbon dioxide, and the like.

Usually, the development replenisher liquid to be supplied to the automatic developing machine 10 needs to be a composition having the same activity level as (in other words, having the same formulation as) that of the developer liquid initially charged into the development bath, or a composition having higher activity than that of the initial developer liquid, in order to recover the activity of the developer liquid that has been deteriorated.

Examples of methods for introducing the development replenisher liquid into the development bath include: (1) a method including separately introducing, into the development bath, water and a development replenisher liquid having higher activity than the initially-employed developer liquid at a predetermined ratio; (2) a method including mixing water and a development replenisher liquid having higher activity than the initially-employed developer liquid at a predetermined ratio in advance so as to dilute the development replenisher liquid, and then introducing the diluted development replenisher liquid into the development bath; and (3) a method including directly introducing a development replenisher liquid of which the concentration has already been adjusted to a predetermined concentration to the development bath.

Conventionally, in the method of (1) or (2), addition of a small amount of a development replenisher liquid having a highest possible concentration (i.e., having highest possible activity) has been practiced in order to decrease the amount of waste liquid generated. However, use of a development replenisher liquid having high activity results in an increase in the salt concentration of the developer liquid in the development bath, as a result of which there is a possibility that undissolved matter that has separated due to development is likely to precipitate. Further, the addition in a small amount requires precise control.

When conventional methods are employed, there has been a problem in that an increase in the addition amount of the development replenisher liquid increases the amount of plate-making process waste liquid to be processed. However, the precipitation of undissolved matter that has separated during development can be suppressed by setting the concentration of the diluted development replenisher liquid, which has a development activity level that is equal to or higher than the that of the initially-employed developer liquid and which is obtained by mixing the development replenisher liquid and regenerated water, to a concentration lower than a standard concentration (a standard concentration of a mixed liquid of the development replenisher liquid and the regenerated water, or a standard concentration of the development replenisher liquid that is used without dilution in the method of (3)) and introducing this diluted development replenisher liquid into the development bath in an amount larger than a standard replenishment amount so as to achieve the same activity. Usually, when it is attempted to maintain the activity constant by adding a development replenisher liquid at a low concentration in a large amount, the concentrations of salts derived from the development replenisher liquid in the development bath are regulated at a low level, and development with high quality can be continued while the generation of a precipitate is suppressed; however, the amount of the development process waste liquid becomes large. However, in the method according to the invention, the regenerated water separated from the development process waste liquid is supplied to the automatic developing machine 10 and reutilized. Therefore, according to the method according to the invention, the proportion of the amount of the development process waste liquid discharged to the outside of the system relative to the amount of supply of the development replenisher liquid can be markedly decreased as compared with conventional methods.

The plate-making process waste liquid according to the invention is concentrated to a degree of concentration in the range of from 1/2.5 to 1/5 (= plate-making process waste liquid after the concentrating / plate-making process waste liquid before the concentrating) in terms of volume, and is preferably concentrated to a degree of concentration in the range of from 1/3 to 1/5. When the degree of concentration is in this range, less dirt occurs in the concentration pot, continuous operation is possible over a long time, the obtained regenerated water can be reutilized, and the amount of waste liquid discharged to the outside of the system as plate-making process waste liquid is very small. In the invention, the degree of concentration is a ratio by volume, and is normalized to a fraction, the denominator of the fraction being the total volume of the plate-making process waste liquid before the concentrating, and the numerator of the fraction being the total volume of the plate-making process waste liquid after the concentrating.

The regenerated water stored in the regenerated water tank 50 is sent to a replenishment water tank 80 via the distillation-regenerated water reutilization apparatus 60. A development replenisher liquid stock solution is transported, as appropriate, from the development replenisher liquid tank 70 to the automatic developing machine 10.

Specific examples of apparatuses for the method of recycling plate-making process waste liquid that can be suitably used in the invention include a planographic printing plate plate-making process waste liquid reducing apparatus disclosed in Japanese Patent No. 4774124, and a waste liquid processing apparatus disclosed in, for example, JP-A No. 2011-90282.

The developer liquid, the development replenisher liquid, and the photosensitive planographic printing plate, which are used in the development of a photosensitive planographic printing plate in the method of recycling plate-making process waste liquid according to the invention, are described below in detail.

### <Developer Liquid>

Next, a developer liquid that is suitable for use in the development of a photosensitive planographic printing plate (a developer liquid for a photosensitive planographic printing plate in the invention) in the method of recycling a development process waste liquid according to the invention is described below in detail. In the present specification, "developer liquid" means both of a development initiating liquid (developer liquid in a narrow sense, which is used at the time of starting development) and a development replenisher liquid, unless specifically indicated otherwise.

Both of a negative developer liquid and a positive developer liquid are both usable as the developer liquid for a photosensitive planographic printing plate according to the invention, and a negative developer liquid is more preferable.

The development replenisher liquid used in the invention includes an organic solvent having a boiling point in the range of from 100°C to 300°C, and the content ratio of organic solvent having a boiling point in the range of from 100°C to 300°C in the development replenisher liquid is in the range of from 5% by mass to 30% by mass. Similar to the development replenisher liquid, the development initiating liquid may also include an organic solvent having a boiling point in the range of from 100°C to 300°C such that the content ratio of organic solvent having a boiling point in the range of from 100°C to 300°C in the development initiating liquid is in the range of from 5% by mass to 30% by mass.

The "developer liquid" described below encompasses a development replenisher liquid, as described above. As described above, when the development replenisher liquid is supplied, the development replenisher liquid may be supplied as its original concentration, or supplied after being diluted with water, in accordance with the purpose. When the development replenisher liquid is diluted, the development replenisher liquid is preferably diluted with water in an amount no more than 10 times (in terms of mass) the amount of the development replenisher liquid, and more preferably diluted with water in an amount that is from 1 time to 7 times (in terms of mass) the amount of the development replenisher liquid.

### [Negative Developer Liquid]

The negative developer liquid in the present specification refers to a developer liquid used in the development of a photosensitive planographic printing plate precursor having a negative image recording layer after the photosensitive planographic printing plate is exposed to light.

The negative developer liquid that can be used in the development of the photosensitive planographic printing plate according to the invention is preferably an alkaline developer liquid at from pH 10 to 12.5, the alkaline developer liquid including at least the organic solvent described above, a hydroxide of an alkali metal, and a surfactant, but not including a silicate compound. The developer liquid used in the invention is preferably a developer liquid for a photosensitive planographic printing plate which has a pH of from 10 to 12.5, and which includes the after-mentioned specific anionic surfactant, and in which the content ratio of specific anionic surfactant in the developer liquid is in the range of from 1.0% by mass to 10% by mass.

### (Organic Solvent)

In the invention, the development replenisher liquid used for the development of a photosensitive planographic printing plate includes an organic solvent having a boiling point in the range of from 100°C to 300°C, and the content ratio of organic solvent having a boiling point in the range of from 100°C to 300°C in the development replenisher liquid is in the range of from 5% by mass to 30% by mass. The development initiating liquid may also include an organic solvent having a boiling point in the range of from 100°C to 300°C such that the content ratio of organic solvent having a boiling point in the range of from 100°C to 300°C in the development initiating liquid is in the range of from 5% by mass to 30% by mass.

When the boiling point of the organic solvent contained in the developer liquid (encompassing the development initiating liquid and the development replenisher liquid) is lower than 100°C, the organic solvent easily evaporates. When the boiling point exceeds 300°C, it becomes more difficult to concentrate the developer. Therefore, a boiling point of the organic solvent of lower than 100°C or higher than 300°C is not preferable.

The content ratio of organic solvent having a boiling point in the range of from 100°C to 300°C that is contained in the developer liquid is in the range of from 5% by mass to 30% by mass, and more preferably in the range of from 5% by mass to 20% by mass. When the content ratio of organic solvent having a boiling point in the range of from 100°C to 300°C is less than 5% by mass, a precipitate is generated in the course of concentrating the plate-making process waste liquid, and washing of the automatic developing machine becomes necessary. When the content ratio of organic solvent having a boiling point in the range of from 100°C to 300°C is higher than 30% by mass, image portions of the planographic printing plate are deteriorated, and the printing durability of the obtained planographic printing plate is deteriorated.

In regard to the type of the organic solvent contained in the developer liquid, any organic solvent that has a boiling point in the range of from 100°C to 300°C may be used. Preferable examples thereof include 2-phenylethanol (boiling point: 219°C), 3-phenyl-1-propanol (boiling point: 238°C), 2-phenoxyethanol (boiling point: 244°C to 255°C), benzyl alcohol (boiling point: 205°C), cyclohexanol (boiling point: 161°C), monoethanolamine (boiling point: 170°C), diethanolamine (boiling point: 268°C), cyclohexanone (boiling point: 155°C), ethyl lactate (boiling point: 155°C), propylene glycol (boiling point: 187°C), ethylene glycol (boiling point: 198°C), γ-butyrolactone (boiling point: 205°C), N-methylpyrrolidone (boiling point: 202°C), N-ethylpyrrolidone (boiling point: 218°C), glycerin (boiling point: 290°C), propylene glycol monomethyl ether (boiling point: 120°C), ethylene glycol monomethyl ether (boiling point: 124°C), ethylene glycol monomethyl ether acetate (boiling point: 145°C), and diethylene glycol dimethyl ether (boiling point: 162°C). In particular, benzyl alcohol, diethanolamine, monoethanolamine, γ-butyrolactone, N-methylpyrrolidone, and N-ethylpyrrolidone are preferable.

The after-mentioned amines of alkali agents are also within the scope of the organic solvent according to the invention as long as the boiling points thereof are in the range of from 100°C to 300°C.

### (Surfactant)

The surfactant contained in the negative developer liquid is preferably an anionic surfactant or a nonionic surfactant.

A most suitable anionic surfactant that can be used in the negative developer liquid is one or more selected from a compound represented by the following Formula (I-A) or a compound represented by the following Formula (I-B).

Preferably, the negative developer liquid as a developer liquid for a photosensitive planographic printing plate includes at least one anionic surfactant selected from the group consisting of anionic surfactants represented by the following Formula (I-A) and anionic surfactants represented by Formula (I-B), such that the content ratio of the at least one anionic surfactant in the negative developer liquid is in the range of from 1.0% by mass to 10% by mass, and also has a pH of from 10 to 12.5.

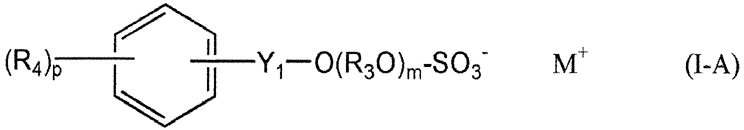

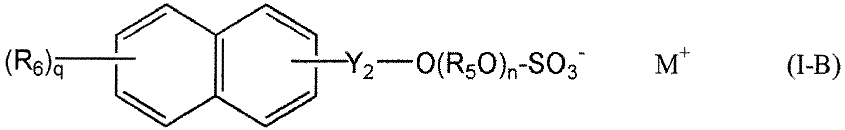

In Formula (I-A), R₃ represents a straight-chain or branched-chain alkylene group having from 1 to 5 carbon atoms; R₄ represents a straight-chain or branched-chain alkyl group having from 1 to 20 carbon atoms; p represents 0, 1 or 2; Y₁ represents a single bond or an alkylene group having from 1 to 10 carbon atoms; m represents an integer from 1 to 100; when m is 2 or greater, plural R₃'s are present, and the plural R₃'s may be the same as or different from each other; and M⁺ represents Na⁺, K⁺, Li⁺ or NH₄⁺.

In Formula (I-B), R₅ represents a straight-chain or branched-chain alkylene group having from 1 to 5 carbon atoms; R₆ represents a straight-chain or branched-chain alkyl group having from 1 to 20 carbon atoms; q represents 0, 1 or 2; Y₂ represents a single bond or an alkylene group having from 1 to 10 carbon atoms; n represents an integer from 1 to 100; when n is 2 or greater, plural R₅'s are present, and the plural R₅'s may be the same as or different from each other; and M⁺ represents Na⁺, K⁺, Li⁺ or NH₄⁺.

In a preferable embodiment of the invention, preferable examples of each of R₃ and R₅ in Formulae (I-A) and (I-B) include -CH₂-, -CH₂CH₂-, and -CH₂CH₂CH₂-, and more preferable examples thereof include -CH₂CH₂-. Preferable examples of each of R₄ and R₆ include CH₃, C₂H₅, C₃H₇ and C₄H₉. Each of p and q preferably represents 0 or 1. Each of Y₁ and Y₂ is preferably a single bond. Further, each of n and m is preferably an integer from 1 to 20.

Specific examples of compounds represented by Formula (I-A) or (I-B) include the following compounds.

(1) 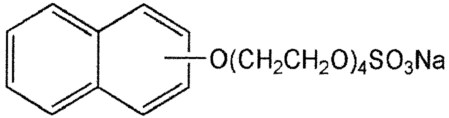
(2) 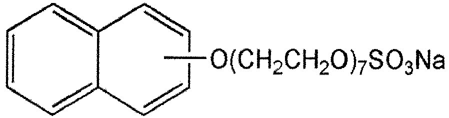
(3) 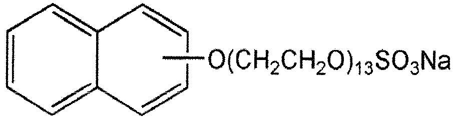
(4) 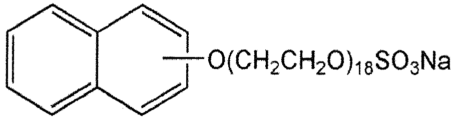
(5) 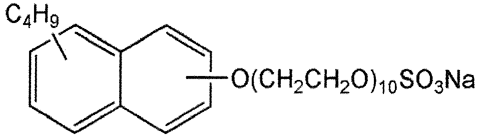
(6) 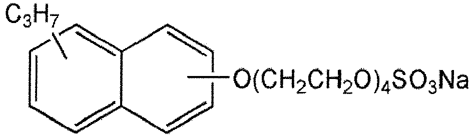
(7) 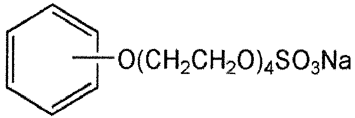
(8) 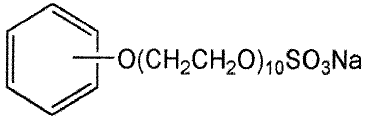
(9) 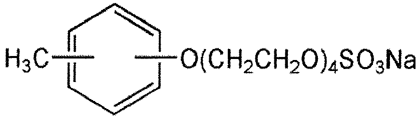
(10)

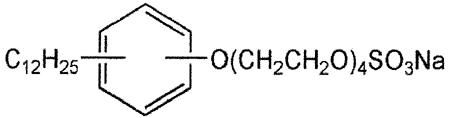

A total content ratio of anionic surfactant in the developer liquid of from 1% by mass to 10% by mass is appropriate, and the total content ratio of anionic surfactant in the developer liquid is preferably from 2% by mass to 10% by mass. When the content ratio of anionic surfactant is 1% by mass or higher, the developability and the dissolvability of image recording layer (photosensitive layer) components are favorable. When the content ratio of anionic surfactant is 10% by mass or lower, the printing durability of the printing plate is favorable.

Preferable examples of the nonionic surfactant include: polyoxyethylene alkyl ethers such as polyoxyethylene naphthyl ether, polyoxyethylene alkyl phenyl ether, polyoxyethylene lauryl ether, polyoxyethylene cetyl ether, and polyoxyethylene stearyl ether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; and monoglyceride alkyl esters such as glycerol monostearate and glycerol monooleate.

Preferable examples of the nonionic surfactant also include a surfactant represented by the following Formula (II-A) and a surfactant represented by Formula (II-B):

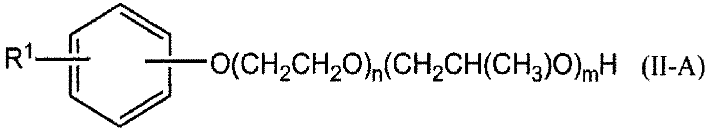

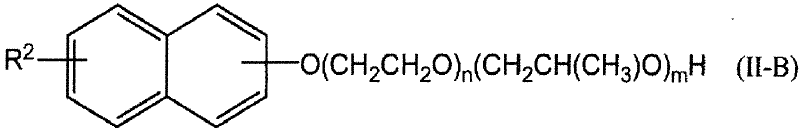

In Formula (II-A), R¹ represents a hydrogen atom or an alkyl group having from 1 to 100 carbon atoms; each of n and m independently represents an integer from 0 to 100, provided that n and m are not simultaneously 0.

In Formula (II-B), R² represents a hydrogen atom or an alkyl group having from 1 to 100 carbon atoms; and each of n and m independently represents an integer from 0 to 100, provided that n and m are not simultaneously 0.

Examples of compounds represented by Formula (II-A) include polyoxyethylene phenyl ether, polyoxyethylene methyl phenyl ether, polyoxyethylene octyl phenyl ether, and polyoxyethylene nonyl phenyl ether. Examples of compounds represented by Formula (II-B) include polyoxyethylene naphthyl ether, polyoxyethylene methyl naphthyl ether, polyoxyethylene octyl naphthyl ether, and polyoxyethylene nonyl naphthyl ether.

In the compound represented by Formula (II-A) and the compound represented by Formula (II-B), the number of the repeating units in the polyoxyethylene chain (n) is preferably from 3 to 50, and more preferably from 5 to 30, and the number of the repeating units in the polyoxypropylene chain (m) is preferably from 0 to 10, and more preferably from 0 to 5. The compound represented by Formula (II-A) or (II-B) may be a random copolymer or a block copolymer with respect to the polyoxyethylene region and the polyoxypropylene region.

The nonionic aromatic ether-based surfactant represented by Formula (II-A) and the nonionic aromatic ether-based surfactant represented by Formula (II-B) are used singly or in combination of two or more thereof.

Specific examples of compounds represented by Formula (II-A) and compounds represented by Formula (II-B) are illustrated below.

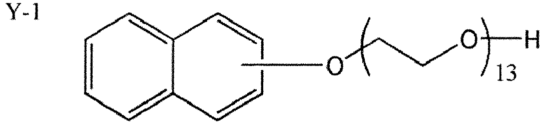

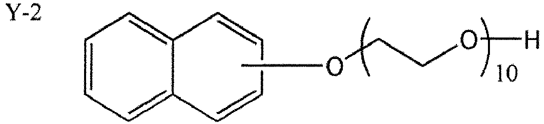

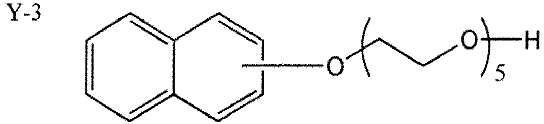

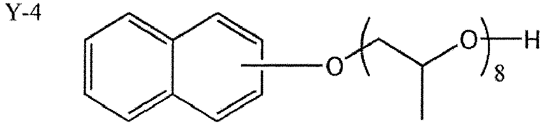

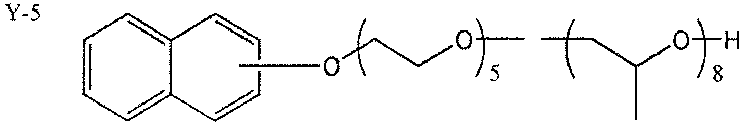

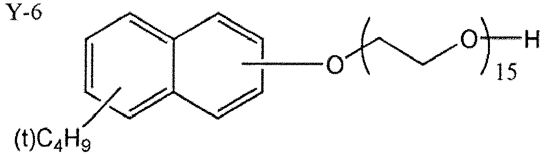

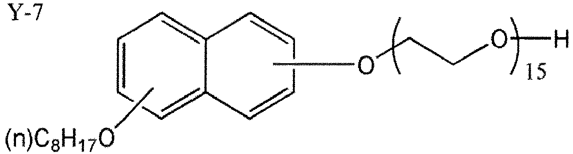

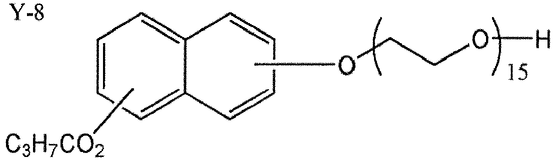

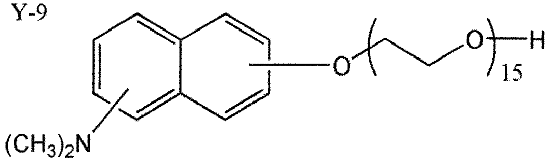

Exemplary compound Y-5 illustrated above may be a random polymer or a block polymer with respect to the oxyethylene repeating region and the oxypropylene repeating region.

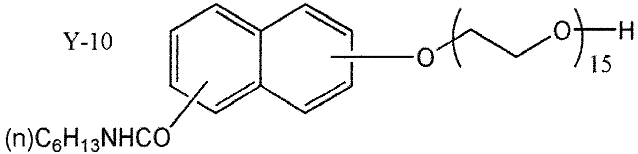

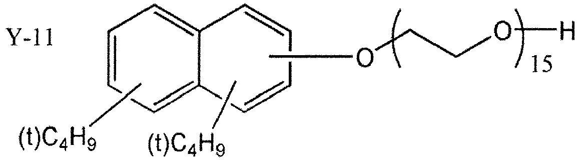

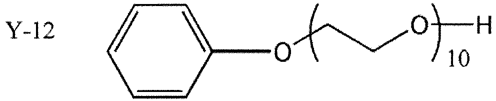

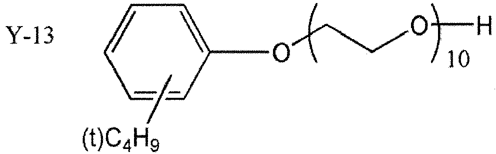

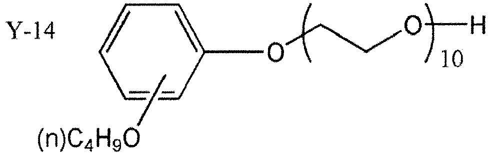

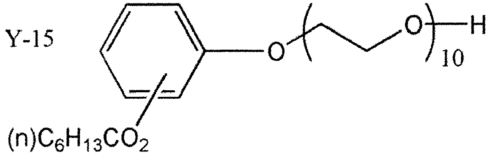

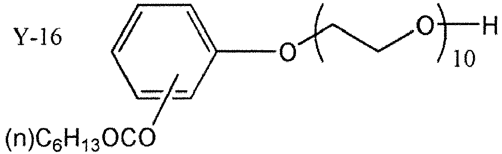

These nonionic surfactants may be used singly or in combination of two or more thereof. The content ratio of nonionic surfactants, such as those described above, in the developer liquid is preferably in the range of from 0.5% by mass to 10% by mass, and more preferably in the range of from 3% by mass to 10% by mass. These preferable ranges of the content ratios of surfactants also apply to the content ratios of surfactants in the development replenisher liquid.

### (Other Components That Can Be Used in Developer Liquid)

The developer liquid may include a chelating agent for a divalent metal. Examples of the divalent metal include magnesium and calcium. Examples of the chelating agent for a divalent metal include: polyphosphoric acid salts such as Na₂P₂O₇, Na₅P₃O₃, Na₃P₃O₉, Na₂O₄P(NaO₃P)PO₃Na₂, and CALGON (poly(sodium metaphosphate)); aminopolycarboxylic acids such as ethylenediaminetetraacetic acid and potassium salts thereof and sodium salts thereof, diethylenetriaminepentaacetic acid and potassium salts thereof and sodium salts thereof, triethylenetetraminehexaacetic acid and potassium salts thereof and sodium salts thereof, hydroxyethylethylenediaminetriacetic acid and potassium salts thereof and sodium salts thereof, nitrilotriacetic acid and potassium salts thereof and sodium salts thereof, 1,2-diaminocyclohexanetetraacetic acid and potassium salts thereof and sodium salts thereof, and 1,3-diamino-2-propanoltetraacetic acid and potassium salts thereof and sodium salts thereof; and organic phosphonic acids such as 2-phosphonobutane-1,2,4-tricarboxylic acid and potassium salts thereof and sodium salts thereof, 2-phosphonobutanone-2,3,4-tricarboxylic acid and potassium salts thereof and sodium salts thereof, 1-phosphonoethane-1,2,2-tricarboxylic acid and potassium salts thereof and sodium salts thereof, 1-hydroxy ethane-1,1-diphosphonic acid and potassium salts thereof and sodium salts thereof, and aminotri(methylenephosphonic acid) and potassium salts thereof and sodium salts thereof.

The optimal amount of these chelating agents may vary with the hardness of water to be used and the amount of water to be used. In general, the content ratio of the chelating agent in the developer liquid at the time of use is preferably in the range of from 0.01% by mass to 5% by mass, and more preferably in the range of from 0.01% by mass to 0.5% by mass.

When an anionic surfactant is contained in the developer liquid, the developer liquid easily foam in some cases. Therefore, the developer liquid may further include an antifoaming agent. When the developer liquid includes an antifoaming agent, the antifoaming agent is preferably contained in the developer liquid at a ratio of 0.00001% by mass or higher, and more preferably at a ratio of about 0.0001% by mass to about 0.5% by mass, with respect to the developer liquid.

Examples of antifoaming agents that can be used in the developer liquid according to the invention include a fluorine-containing antifoaming agent, a silicone-based antifoaming agent, an acetylene alcohol, and an acetylene glycol.

Examples of the fluorine-containing antifoaming agent include a compound represented by the following formula, polyoxyethylene alkyl ether, polyoxyethylene alkyl aryl ether, and polyoxyethylene polyoxypropylene ether.

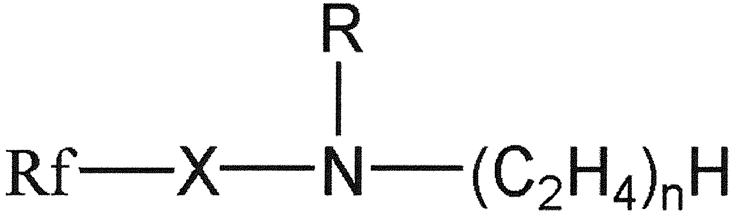

In the formula, R represents H or an alkyl group; Rf represents a fluorocarbon group (having from about 5 to about 10 carbon atoms) in which some or all of H atoms of its alkyl group are substituted with F atoms; X represents CO or SO₂; and n represents an integer from about 1 to about 10.

Among the above-mentioned examples of the fluorine-containing antifoaming agent, fluorine-containing antifoaming agents having an HLB value of from 1 to 9, in particular fluorine-containing antifoaming agents having an HLB value of from 1 to 4, are preferable. The fluorine-containing antifoaming agent described above is added, as it is, to the developer liquid or added, in the form of an emulsion liquid mixed with water or a solvent other than water, to the developer liquid.

Examples of silicone-based antifoaming agents that may be used include:
dialkylpolydioxane, preferably dimethylpolydioxane shown below itself, or the dimethylpolydioxane shown below formed into an O/W emulsion liquid;

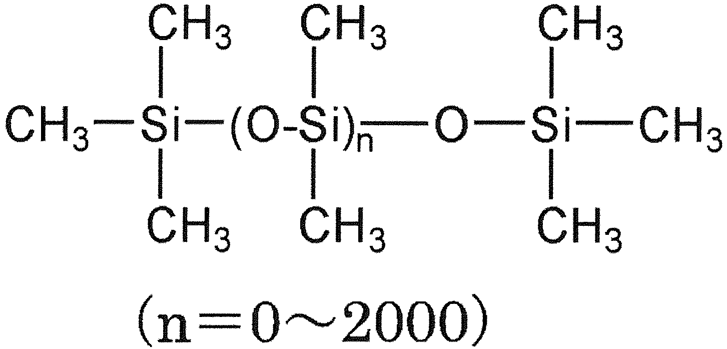

the alkoxypoly(ethyleneoxy)siloxane shown below: 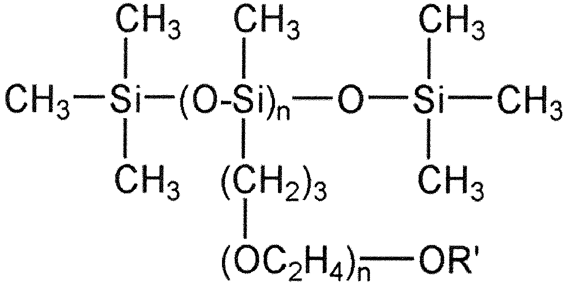 (n: from 6 to 10, R': a lower alkyl having from 1 to 4 carbon atoms) 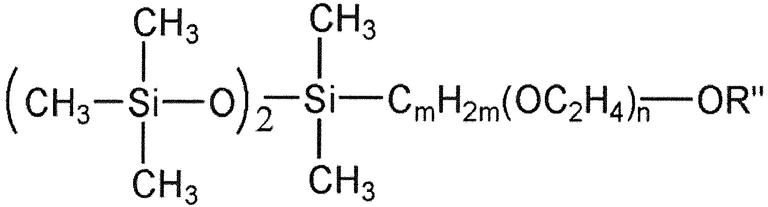 (m: from 2 to 4, n: from 4 to 12, R': a lower alkyl having from 1 to 4 carbon atoms)

a product obtained by modifying dimethylpolydioxane by introduction of carboxylic acid groups or sulfonic acid groups into parts of the dimethylpolydioxane; and an emulsion liquid obtained by mixing any of these silicone compounds with water and a generally known anionic surfactant.

An acetylene alcohol is an unsaturated alcohol having an acetylene bond (triple bond) in a molecule thereof. An acetylene glycol is also referred to as an alkylene diol, and is an unsaturated glycol having an acetylene bond (triple bond) in a molecule thereof.

More specifically, examples thereof include compounds represented by the following Formula (1) and compounds represented by the following Formula (2):

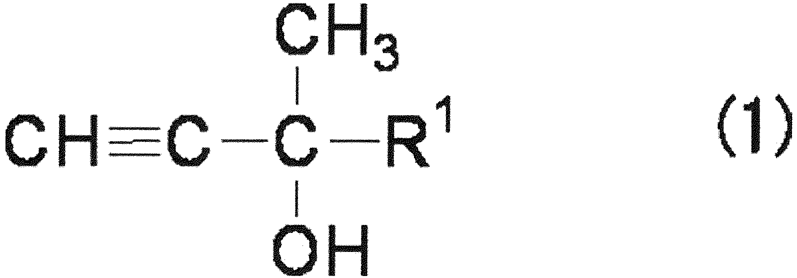

In Formula (1), R¹ represents a straight-chain or branched-chain alkyl group having from 1 to 5 carbon atoms.

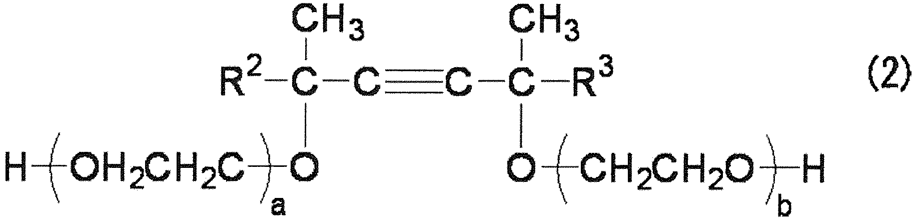

In Formula (2), each of R² and R³ independently represents a straight-chain or branched-chain alkyl group having from 1 to 5 carbon atoms; and each of a and b independently represents an integer of 0 or greater, provided that a + b is in the range of from 0 to 30.

In Formula (2), examples of the straight-chain or branched-chain alkyl group having from 1 to 5 carbon atoms include a methyl group, an ethyl group, an isopropyl group, an isobutyl group, and an isopentyl group.

Specific examples of acetylene alcohols and acetylene glycols further include the following:
(1) propargyl alcohol
(2) propargyl carbinol
(3) 3,5-dimethyl-1-hexyn-3-ol
(4) 3-methyl-1-butyn-3-ol
(5) 3-methyl-1-pentyn-3-ol
(6) 1,4-butynediol
(7) 2,5-dimethyl-3-hexyne-2,5-diol
(8) 3,6-dimethyl-4-octyne-3,6-diol
(9) 2,4,7,9-tetramethyl-5-decyne-4,7-diol
(10) ethylene oxide adduct of 2,4,7,9-tetramethyl-5-decyne-4,7-diol (structure described below).

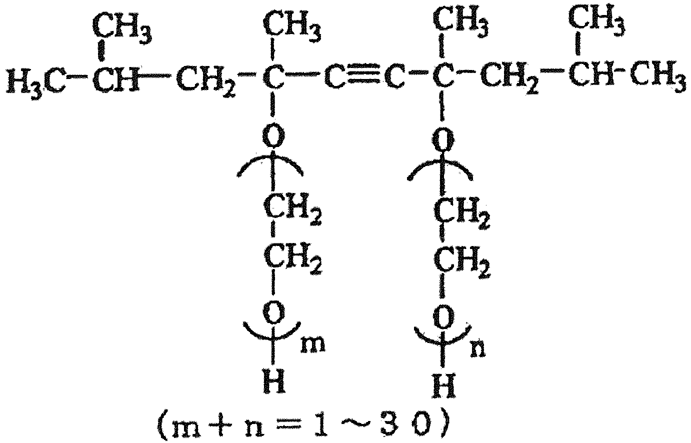

### (11) 2,5,8,11-tetramethyl-6-dodecyne-5,8-diol

These acetylene alcohols and acetylene glycols are available from the market, and examples of known commercial products include trade name SURFINOL series of Air Products and Chemicals, Inc., and trade name OLFINE series manufactured by Nisshin Chemical Co., Ltd. Specific examples of commercially available products include SURFINOL 61 (trade name), which is the compound (3) above; OLFINE B (trade name), which is the compound (4) above; OLFINE P (trade name), which is the compound (5) above; OLFINE Y (trade name), which is the compound (7) above; SURFINOL 82 (trade name), which is the compound (8) above; SURFINOL 104 (trade name) and OLFINE AK-02 (trade name), which are the compound (9) above; SURFINOL 400 series (trade name), which are the compound (10) above; and SURFINOL DF-110 (trade name), which is the compound (11) above.

The negative developer liquid may include, as a development adjusting agent, one or more compounds selected from the group consisting of alkali metal salts of organic acids and alkali metal salts of inorganic acids. For example, the negative developer liquid may include one selected from, or a combination of two or more selected from, sodium carbonate, potassium carbonate, ammonium carbonate, sodium citrate, potassium citrate, and ammonium citrate, and the like.

The negative developer liquid may include, as an alkali agent, one selected from, or a combination of two or more selected from, inorganic alkali agents such as trisodium phosphate, tripotassium phosphate, triammonium phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide.

Besides the components described above, the negative developer liquid may further include, for example, a component selected from the following in accordance with necessity: organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-t-butylbenzoic acid, p-2-hydroxyethylbenzoic acid, decanoic acid, salicylic acid, and 3-hydroxy-2-naphthoic acid; organic solvents such as isopropyl alcohol, benzyl alcohol, ethyl cellosolve, butyl cellosolve, phenyl cellosolve, propylene glycol, and diacetone alcohol; chelating agents; reducing agents; dyes; pigments; hard-water softening agents; and antiseptics.

The pH of the negative developer liquid may be from 10 to 12.5, and is preferably from 11 to 12.5. The conductivity x of the negative developer liquid is preferably higher than 2 mS/cm but lower than 30 mS/cm, and more preferably from 5 mS/cm to 25 mS/cm.

The negative developer liquid may include one or more selected from alkali metal salts of organic acids and alkali metal salts of inorganic acids, as a conductivity adjusting agent for adjusting conductivity.

### [Positive Developer Liquid]

A positive developer liquid in the present specification means a developer liquid used for development after light exposure of a photosensitive planographic printing plate having a positive image recording layer.

The developer liquid (including development replenisher liquid) used in the development of a photosensitive planographic printing plate in the invention is preferably an alkali developer liquid that includes an organic compound having a buffer action and a base as main components other than the specific organic solvent, and that does not substantially include a silicate compound. In the invention, such a developer liquid shall hereinafter be referred to as a "non-silicate developer liquid". Here, the term "substantially" means that the presence of unavoidable impurities and a trace amount of silicate compound as a by-product is permitted.

### (Organic Solvent)

The positive developer liquid described below in detail includes an organic solvent having a boiling point in the range of from 100°C to 300°C at a content ratio in the range of from 5% by mass to 30% by mass. With respect to examples and preferable examples of these organic solvents, the above-described examples and preferable examples of the organic solvent in the negative developer liquid can be applied as they are.

### (Non-reducing Sugar and Base)

The most generally employed conventional developer liquids for photosensitive planographic printing plates are aqueous solutions including a silicate such as sodium silicate or potassium silicate. This is because developing power can be controlled to a certain extent by the ratio between silicon oxide SiO₂ and an alkali metal oxide M₂O (generally expressed by a molar ratio [SiO₂ / [M₂O], which are components of a silicate, and by the concentrations thereof. A further reason is that almost all positive photosensitive planographic printing plates require strong alkali at or around pH 13 for development thereof, and silicates exhibit a satisfactory buffering action in that pH region, and resultantly enables stable development.

However, silicates, which are main components, have defects in that, although silicates are stable in an alkaline region, silicates gelate and become insoluble at neutral pH, and become only soluble in strong acids, as hydrofluoric acid, when precipitated through solidification due to drying through evaporation. In the process of concentrating the plate-making process waste liquid, since a silicate thus becomes insoluble and precipitate, the silicate that has become insoluble needs to be removed in order to transfer the concentrated liquid to another vessel, or in order to continuously perform concentrating operation, as a result of which maintainability of the concentration apparatus is markedly decreased.

Non-silicate developer liquids include main components that are at least one base and at least one compound selected from non-reducing sugars. Non-silicate developer liquids are used with their pH adjusted to be in the range of from about 9.0 to about 13.5.

The non-reducing sugars are sugars that do not have a free aldehyde group or a free ketone group, and that do not exhibit reducing properties. Non-reducing sugars are classified into: trehalose-type oligosaccharides in which reducing groups are bonded to each other; glycosides in which a reducing group of a sugar is bonded to a non-sugar; and sugar alcohols obtained by reducing sugars by hydrogenation. All of these can be suitably used in the invention. Examples of trehalose-type oligosaccharides include saccharose and trehalose, and examples of glycosides include alkyl glycosides, phenol glycosides, and mustard oil glycosides. Examples of sugar alcohols include D,L-arabitol, ribitol, xylitol, D,L-sorbitol, D,L-mannitol, D,L-iditol, D,L-talitol, dulcitol, and allodulcitol. Maltitol obtained by hydrogenation of disaccharides, and reduced forms (reduced sugar syrup) obtained by hydrogenation of oligosaccharides, can also be suitably used. Among these, sugar alcohols and saccharose are preferable as non-reducing sugars that can be used in the developer liquid according to the invention, and, particularly, D-sorbitol, saccharose, and reduced sugar syrup are preferable due to their buffering action in a suitable pH region and their low costs.

These non-reducing sugars may be be used singly or in combination of two or more thereof, and the proportion of non-reducing sugar in the developer liquid is preferably 0.1% by mass to 30% by mass, and more preferably 1% by mass to 20% by mass. When the proportion is in this range, a sufficient buffering action is obtained, concentrating to a high extent can be performed easily, and costs can be lowered.

When a reducing sugar is used in combination with a base, there is a problem in that coloration into brown occurs over time, and pH gradually decreases, as a result of which developing power decreases.

Conventionally known alkali agents may be used as a base to be combined with a non-reducing sugar. Examples thereof include inorganic alkali agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogen carbonate, potassium hydrogen carbonate, ammonium hydrogen carbonate, sodium borate, potassium borate, and ammonium borate. Organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine are also usable.

These alkali agents may be used singly, or in combination of two or more thereof. Among these, sodium hydroxide and potassium hydroxide are preferable. The reason therefor is that pH adjustment over a wide pH range is made possible by adjusting the amount of these substances relative to the amount of non-reducing sugar. Trisodium phosphate, tripotassium phosphate, sodium carbonate, and potassium carbonate, for example, are also preferable due to their own buffering activity.

It should be noted that amines of the alkali agents described above are also included in the scope of the organic solvent having a boiling point in the range of from 100°C to 300°C according to the invention as long as the boiling points of the amines of the alkali agents are in the range of from 100°C to 300°C. The amines of the alkali agents are regarded as organic solvents having a boiling point in the range of from 100°C to 300°C also in the calculation of the content ratio of organic solvent having a boiling point in the range of from 100°C to 300°C, as long as the boiling points of the amines of the alkali agents are in the range of from 100°C to 300°C.

When an alkali agent is included in the developer agent, the alkali agent is included into the developer agent such that the pH of the developer liquid is in the range of from 9.0 to 13.5. The content of alkali agent may be determined based on the desired pH and the type and content of the non-reducing sugar. The pH of the developer liquid is more preferably in the range of from 10.0 to 13.2.

In the positive developer liquid, an alkaline buffer solution composed of a weak acid other than sugars and a strong base may be used in combination. The weak acid that is used in such a buffer solution preferably has a dissociation constant (pKa) of from 10.0 to 13.2. Such a weak acid may be selected from those disclosed in, for example, "IONISATION CONSTANTS OF ORGANIC ACIDS IN AQUEOUS SOLUTION" published by Pergamon Press, Ltd., and examples thereof include: alcohols such as 2,2,3,3-tetrafluoro-1-propanol (pKa 12.74), trifluoroethanol (pKa 12.37), and trichloroethanol (pKa 12.24); aldehydes such as pyridine-2-aldehyde (pKa 12.68) and pyridine-4-aldehyde (pKa 12.05); compounds having a phenolic hydroxyl group, such as salicylic acid (pKa 13.0), 3-hydroxy-2-naphthoic acid (pKa 13.84), catechol (pKa 12.6), gallic acid (pKa 12.4), sulfosalicylic acid (pKa 11.7), 3,4-dihydroxysulfonic acid (pKa 12.2), 3,4-dihydroxybenzoic acid (pKa 11.94), 1,2,4-trihydroxybenzene (pKa 11.82), hydroquinone (pKa 11.56), pyrogallol (pKa 11.34), o-cresol (pKa 10.33), resorcinol (pKa 11.27), p-cresol (pKa 10.27), and m-cresol (pKa 10.09); oximes such as 2-butanone oxime (pKa 12.45), acetoxime (pKa 12.42), 1,2-cycloheptanedione dioxime (pKa 12.3), 2-hydroxybenzaldehyde oxime (pKa 12.10), dimethylglyoxime (pKa 11.9), ethanediamide dioxime (pKa 11.37), and acetophenone oxime (pKa 11.35); nucleic acid-related substances such as adenosine (pKa 12.56), inosine (pKa 12.5), guanine (pKa 12.3), cytosine (pKa 12.2), hypoxanthine (pKa 12.1) and xanthine (pKa 12.9); and weak acids such as diethylaminomethyl phosphonic acid (pKa 12.32), 1-amino-3,3,3-trifluorobenzoic acid (pKa 12.29), isopropylidene diphosphonic acid (pKa 12.10), 1,1-ethylidene diphosphonic acid (pKa 11.54), 1-hydroxy ethylidene-1,1-diphosphonic acid (pKa 11.52), benzimidazole (pKa 12.86), thiobenzamide (pKa 12.8), picoline thioamide (pKa 12.55), and barbituric acid (pKa 12.5).

Among these weak acids, sulfosalicylic acid and salicylic acid are preferable. sodium hydroxide, ammonium hydroxide, potassium hydroxide, and lithium hydroxide are preferable as a base to be combined with these weak acids. These alkali agents may be used singly, or in combination of two or more thereof.

The various alkali agents described above are used so as to adjust the pH to be within a preferable range, by adjusting the concentrations and combinations thereof.

### (Surfactant)

A positive developer liquid may further include various surfactants, if necessary, in order to, for example, enhance developing power, disperse development residues, or increase the ink affinity of image areas of printing plates. Examples of preferable surfactants include anionic surfactants, cationic surfactants, nonionic surfactants, and amphoteric surfactants.

Preferable examples of the surfactant used in the positive developer liquid include: nonionic surfactants, for example, polyoxyethylene alkyl ethers, glycerin fatty acid partial esters, sorbitan fatty acid partial esters, sucrose fatty acid partial esters, fatty acid diethanolamides, polyoxyethylene alkylamines, triethanolamine fatty acid esters, and trialkylamine oxides; anionic surfactants such as fatty acid salts, dialkylsulfosuccinic acid ester salts, straight-chain alkylbenzenesulfonic acid salts, polyoxyethylene alkyl sulfophenyl ether salts, sulfuric acid ester salts of fatty acid alkyl esters, and polyoxyethylene alkyl ether sulfuric acid ester salts; cationic acid surfactants, for example, quaternary ammonium salts such as alkylamine salts and tetrabutylammonium bromide, polyoxyethylene alkylamine salts, and polyethylene polyamine derivatives; and amphoteric surfactants, for example, carboxybetaines, aminocarboxylic acids, sulfobetaines, aminosulfuric acid esters, and imidazolines.

A more preferable surfactant is a fluorine-containing surfactant including a perfluoroalkyl group in a molecule thereof. Examples of the fluorine-containing surfactant include: anionic fluorine-containing surfactants such as perfluoroalkylcarboxylic acid salts, perfluoroalkylsulfonic acid salts, and perfluoroalkyl phosphoric acid esters; amphoteric fluorine-containing surfactants such as perfluoroalkylbetaines; cationic fluorine-containing surfactants such as perfluoroalkyltrimethylammonium salts; and nonionic surfactants such as perfluoroalkylamine oxide, perfluoroalkylethylene oxide adducts, oligomers including a perfluoroalkyl group and a hydrophilic group, oligomers including a perfluoroalkyl group and an oleophilic group, oligomers including a perfluoroalkyl group, a hydrophilic group and an oleophilic group, and urethanes including a perfluoroalkyl group and an oleophilic group.

The surfactant described above may be used alone, or two or more thereof may be used in combination. The surfactant may be included in the developer liquid such that the content ratio of surfactant in the developer liquid is in the range of from 0.5% by mass to 10% by mass, and more preferably in the range of from 3% by mass to 10% by mass.

A content ratio of surfactant in the developer liquid in the range described above is preferable from the viewpoints of preventing impairment of stability of the concentrating operation due to foaming of surfactant in the distillation process and preventing an increase of work load for maintenance of automatic developing machine or the like caused by contamination of the facilities with plate-making process waste liquid due to foaming. A content ratio of surfactant in the developer liquid in the range described above is also preferable from the viewpoints of obtaining sufficient developability so as to suppress the generation of development residues from an image forming layer in the developer liquid, and preventing a decrease in the service life of the developer liquid caused by the presence of the surfactant.

### (Development Stabilizer)

In the developer liquid according to the invention, various development stabilizers may be used. Preferable examples thereof include polyethylene glycol adducts of sugar alcohols disclosed in JP-A No. H06-282079, tetraalkylammonium salts such as tetrabutylammonium hydroxide, phosphonium salts such as tetrabutylphosphonium bromide, and iodonium salts such as diphenyliodonium chloride.

### (Reducing Agent)

The positive developer liquid may further include a reducing agent. A reducing agent prevents contamination of the printing plate. Examples of preferable organic reducing agents include phenolic compounds such as hydroquinone and resorcin, and amine compounds such as phenylenediamine and phenylhydrazine. Examples of more preferable inorganic reducing agents include sodium salts, potassium salts and ammonium salts of inorganic acids such as sulfurous acid, hydrogen sulfurous acid, phosphorous acid, hydrogen phosphorous acid, dihydrogen phosphorous acid, thiosulfuric acid, and dithionous acid. Among these reducing agents, sulfurous acid salts are particularly excellent in contamination preventing effect. In the case of using a reducing agent, the reducing agent is preferably included in the developer liquid such that the content ratio of reducing agent is in the range of from 0.05% by mass to 5% by mass with respect to the developer liquid at the time of use.

### (Other Additives)

The positive developer liquid may further include known additives, as necessary. For example, the positive developer liquid may include an additive selected from the group consisting of organic carboxylic acids, antiseptic agents, colorants, thickening agents, antifoaming agents, and hard-water softening agents.

### (Water)

The component occupying the remaining part of the negative developer liquid or the positive developer liquid described above is water. The developer liquid according to the invention may be prepared in the form of a developer stock solution. That is, it is beneficial, in terms of transport, to prepare the developer liquid according to the invention as a concentrate liquid in which the content of water is smaller than that at the time of use, and to dilute the concentrate liquid with water at the time of use. A degree of concentration appropriate in this case is a concentration at which each of the components does not separate or precipitate.

When development is carried out using an automatic developing machine, it is known that processing of a large amount of planographic printing plates without replacing the developer liquid in the developer tank for a long time is enabled by adding an aqueous solution (development replenisher liquid) having a higher alkali strength than that of the development initiating liquid to the developer liquid. In the present invention, this replenishment method is preferably applied.

As described above, the developer liquid (including the development replenisher liquid) may include a substance selected from the group consisting of various surfactants and organic solvents in accordance with the necessity, with a view to enhancing or decreasing developing power, dispersing development residues, and increasing the ink affinity of image areas of printing plates. The developer liquid (including the development replenisher liquid) may include a reducing agent such as hydroquinone, resorcin, a sodium salt or potassium salt of an inorganic acid such as sulfurous acid or hydrogen sulfurous acid, as necessary; further, the developer liquid (including the development replenisher liquid) may include an organic carboxylic acid, a antifoaming agent, or a hard-water softening agent.

### <Photosensitive Planographic Printing Plate>

A photosensitive planographic printing plate that can preferably be used in the method of recycling plate-making process waste liquid according to the invention is described below in detail. First, a negative planographic printing plate is described, and then a positive planographic printing plate is described. In addition, the term "photosensitive planographic printing plate" as used herein means a photosensitive planographic printing plate precursor, and these terms are used interchangeably.

### [Negative Planographic Printing Plate]

In the method of recycling plate-making process waste liquid according to the invention, a particularly significant effect can be obtained by using the negative planographic printing plate described in detail below. Therefore, it is preferable to use a negative planographic printing plate. A negative planographic printing plate has a negative image recording layer including a negative photosensitive composition on a support.

That is, preferable examples of photosensitive compositions that can be used in the negative recording layer of the photosensitive planographic printing plate to be processed in the method of recycling plate-making process waste liquid according to the invention include a so-called heat-polymerization or thermal-polymerization photosensitive composition that includes an infrared absorber, a polymerization initiator, an ethylenically unsaturated bond-containing monomer, and a binder polymer, or a so-called photopolymerization photosensitive composition that includes a photopolymerization initiating system, a photopolymerizable composition, and a binder polymer. A photopolymerization photosensitive composition is described below.

### [Photopolymerization Photosensitive Composition]

A photopolymerization photosensitive composition, which is an example of a photosensitive composition used in the image recording layer of the negative planographic printing plate for planographic printing plate production to be processed in the method of recycling plate-making process waste liquid according to the invention, includes a photopolymerization initiating system that responds to light in the wavelength region from visible light to ultraviolet light, a polymerizable compound having at least one ethylenically unsaturated group, and a binder polymer.

The photosensitive composition is applied to a support, such as an aluminum plate, to provide a photosensitive layer (image recording layer), and the resultant can be used as a photosensitive planographic printing plate. Such a photosensitive planographic printing plate has a configuration in which an image recording layer and, optionally, a protective layer are sequentially layered on a support. In addition to the image recording layer and a protective layer that is optionally provided, an undercoat layer or the like may further be provided, as desired. In a case in which a protective layer and an undercoat layer are to be provided, an undercoat layer, an image recording layer, and a protective layer may be provided on a support in this order. As described above, an undercoat layer and a protective layer may be provided, as necessary, and another layer that can be provided in accordance with the purpose (for example, an intermediate layer, a backcoat layer, or the like) may further be provided.

### (Photopolymerization Initiating System Responsive to Light in Wavelength Region from Visible Light to Ultraviolet Light)

A photopolymerization initiating system responsive to light in the wavelength region from visible light to ultraviolet light means a system that includes a compound capable of initiating photopolymerization by absorbing light in the wavelength region from visible light to ultraviolet light. More specific example thereof is a combination of a sensitizing colorant having a maximum absorption wavelength in the wavelength region from visible light to ultraviolet light, preferably, from 330 nm to 700 nm, and a photopolymerization initiator. Two or more photopolymerization initiators may be used in the photopolymerization initiating system (combined use system). In regard to these photopolymerization initiating systems, a photopolymerization initiating system can be established by appropriately selection from various sensitizing colorants (dyes) and various photoinitiators known in patents and literature, or from various combined use systems of two or more photoinitiators known in patents and literature, in accordance with the wavelength of the light source to be employed.

Even in a case in which visible light of 400 nm or longer, an Ar laser, a second harmonic wave of a semiconductor laser, and a SHG-YAG laser are used as light sources, various photoinitiating systems have been proposed. Examples thereof include: photoreductive dyes disclosed in US Patent No. 2,850,445, for example, Rose Bengal, eosin, and erythrosine; or polymerization initiating systems composed of combinations of dyes and initiators, such as the following polymerization initiating systems:
a complex initiating system of a dye and an amine (Japanese Patent Publication (JP-B) No. S44-20189), a system in which a hexaarylbiimidazole, a radical generator, and a dye are used in combination (JP-B No. S45-37377), a system of a hexaarylbiimidazole and a p-dialkylaminobenzylidene ketone (JP-B No. S47-2528, JP-ANo. S54-155292), a system of a cyclic cis-α-dicarbonyl compound and a dye (JP-A No. S48-84183), a system of a cyclic triazine and a merocyanine dye (JP-A No. S54-151024), a system of 3-ketocoumarin and an activator (JP-A No. S52-112681 and JP-A No. S58-15503), a system of a biimidazole, a styrene derivative and a thiol (JP-ANo. S59-140203), a system of an organic peroxide and a dye (JP-ANos. S59-1504, S59-140203, S59-189340, and S62-174203, JP-B No. S62-1641, and US Patent No. 4766055), a system of a dye and an activated halogen compound (for example, JP-A Nos. S63-258903 and H02-63054), a system of a dye and a borate compound (for example, JP-A Nos. S62-143044, S62-150242, S64-13140, S64-13141, S64-13142, S64-13143, S64-13144, S64-17048, H01-229003 H01-298348, and H01-138204), a system of a dye having a rhodanine ring and a radical generator (JP-A Nos. H02-179643 and H02-244050), a system of a titanocene and a 3-ketocoumarin dye (JP-ANo. S63-221110), a system of a titanocene, a xanthenes dye, and an addition-polymerizable ethylenically unsaturated compound that contains an amino group or a urethane group (JP-A Nos. H04-221958 and H04-219756), a system of a titanocene and a specific merocyanine dye (JP-A No. H06-295061), and a system of a titanocene and a dye having a benzopyrane ring (JP-A No. H08-334897).

Recently, lasers having a wavelength of from 400 nm to 410 nm (violet lasers) have been developed, and photopolymerization initiating systems responsive thereto which exhibits high sensitivity to a wavelength of 450 nm or less have been developed. These photoinitiating systems are also usable. Examples thereof include a cationic dye/borate system (JP-A No. H11-84647), a merocyanine dye/titanocene system (JP-A No. 2000-147763), and a carbazole type dye/titanocene system (JP-A No. 2001-42524).

It is known that photoinitiation ability can be further enhanced by adding, to the photoinitiating system, a hydrogen-donating compound, for example, a thiol compound such as 2-mercaptobenzothiazole, 2-mercaptobenzimidazole, or 2-mercaptobenzoxazole, or an amine compound, for example, N-phenylglycine or an N,N-dialkylamino aromatic alkyl ester, if necessary. The usage amount of photopolymerization initiating system, such as those described above, may be adjusted to be in the range of from 0.05 parts by mass to 100 parts by mass, preferably in the range of from 0.1 parts to 70 parts by mass, and more preferably in the range of from 0.2 parts to 50 parts by mass, with respect to 100 parts by mass of the after-mentioned ethylenically unsaturated compound.

### (Polymerizable Compound Having At Least One Ethylenically Unsaturated Group)

A polymerizable compound having at least one ethylenically unsaturated group (hereinafter also referred to as an "ethylenically unsaturated bond-containing compound") is a compound that has an ethylenically unsaturated bond, and that undergoes addition polymerization due to the action of a photopolymerization initiator so as to crosslink and cure when the photosensitive composition is irradiated with an actinic light. The compound containing an addition-polymerizable ethylenically unsaturated bond can be freely selected from compounds having at least one terminal ethylenically unsaturated bond, and preferably having two or more terminal ethylenically unsaturated bonds. The ethylenically unsaturated bond-containing compound has a chemical form such as a monomer, a prepolymer (i.e., a dimer, a trimer, or an oligomer), or a mixture thereof or a copolymer thereof.

Examples of the monomer and copolymers thereof include an ester of an unsaturated carboxylic acid (for example, acrylic acid, methacrylic acid, itaconic acid, crotonic acid, isocrotonic acid, or maleic acid) and an aliphatic polyhydric alcohol compound, and an amide of an unsaturated carboxylic acid and aliphatic polyvalent amine compound.

When the monomer is an ester of an aliphatic polyhydric alcohol compound and an unsaturated carboxylic acid, specific examples thereof include acrylic acid esters, methacrylic acid esters, itaconic acid esters, crotonic acid esters, isocrotonic acid esters, and maleic acid esters.

Examples of acrylic acid esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimetylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Examples of itaconic acid esters include ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetradicrotonate.

Examples of isocrotonic acid esters include ethylene glycol diisocrotonate, pentaerythritol diisocrotonate, and sorbitol tetraisocrotonate.

Examples of maleic acid esters include ethylene glycol dimaleate, triethylene glycol dimaleate, pentaerythritol dimaleate, and sorbitol tetramaleate.

Examples also include a mixture of two or more of the ester monomers described above.

Specific examples of the monomers of amides of aliphatic polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylene bismethacrylamide.

Other examples include a vinylurethane compound that includes two or more polymerizable vinyl groups in one molecule, and that is obtained by adding a hydroxyl group-containing vinyl monomer represented by the following Formula (A) to a polyisocyanate compound having two or more isocyanate groups in one molecule, which is disclosed in JP-B No. S48-41708.

CH₂=C(R)COOCH₂CH(R')OH (A)

Here, each of R and R' represents H or CH₃.

Further examples include polyfunctional acrylates or methacrylates, including: urethane acrylates disclosed in JP-A No. S51-37193 and JP-B No. H02-32293; polyester acrylates disclosed in JP-A No. S48-64183 and JP-B Nos. S49-43191 and S52-30490; and epoxy acrylates obtained by allowing epoxy resins to react with (meth)acrylic acid.

### (Binder Polymer)

A binder polymer (high-molecular-weight binder) in the photopolymerization photosensitive composition is requested to function as a film forming agent for the image recording layer and also needs to dissolve in an alkali developer liquid, an organic high-molecular-weight polymer that is soluble or swellable in alkaline water is used as the binder polymer.

Examples of such an organic high-molecular-weight polymer include addition polymers having a carboxylic acid group in a side chain thereof, for example, those disclosed in JP-A No. S59-44615, JP-B Nos. S54-34327, S58-12577 and S54-25957, JP-A Nos. S54-92723, S59-53836 and S59-71048, more specifically, methacrylic acid copolymers, acrylic acid copolymers, itaconic acid copolymers, crotonic acid copolymers, maleic acid copolymers, and partially-esterified maleic acid copolymers.

Other examples of the organic high-molecular-weight polymer soluble or swellable in alkaline water include acidic cellulose derivatives having a carboxylic acid group in a side chain thereof. Still other examples include a product obtained by adding a cyclic acid anhydride to an addition polymer having a hydroxyl group. In particular, among these, a copolymer of benzyl (meth)acrylate, (meth)acrylic acid, and, optionally, another addition polymerizable vinyl monomer, and a copolymer of allyl (meth)acrylate, (meth)acrylic acid, and, optionally, another addition polymerizable vinyl monomer, are preferable. In addition to these, polyvinyl pyrrolidone, polyethylene oxide, and the like are useful as water-soluble organic high-molecular-weight compound. From the viewpoint of increasing the strength of a cured film, alcohol-soluble polyamides, polyether of 2,2-bis(4-hydroxyphenyl)propane and epichlorohydrin, and the like are also useful as the organic high-molecular-weight polymer.

Polyurethane resins disclosed in JP-B Nos. H07-120040, H07-120041, H07-120042, and H08-12424, and JP-A Nos. S63-287944, S63-287947, H01-271741, and H11-352691, are useful from the viewpoint of application to the invention.

Introduction of radical reactive groups into side chains of these high-molecular-weight polymers enhances the strength of the resultant cured coating films. Examples of the radical reactive groups include: a functional group capable of addition polymerization reaction, such as an ethylenically unsaturated bond group, an amino group, or an epoxy group; and a functional group capable of becoming a radical when irradiation with light, such as a mercapto group, a thiol group, a halogen atom, a triazine structure, or an onium salt structure. The functional group capable of addition polymerization reaction is particularly preferably an ethylenically unsaturated bond group such as an acrylic group, a methacrylic group, an allyl group or a styryl group. Nevertheless, a functional group selected from the group consisting of an amino group, a hydroxyl group, a phosphonic acid group, a phosphoric acid group, a carbamoyl group, an isocyanate group, a ureido group, a ureylene group, a sulfonic acid group, and an ammonio group is also useful.

In order to maintain the developability of the image recording layer, the binder polymer preferably has an appropriate molecular weight and an appropriate acid value, and high-molecular-weight polymers having a weight average molecular weight of from 5000 to 300,000 and an acid value of from 20 to 200 are effectively employed.

The amount of binder polymer contained in the photopolymerization composition can be set to any desired amount, and the content ratio of binder polymer is preferably from 10% by mass to 90% by mass, and more preferably 30% by mass to 80% by mass. When the amount of binder polymer contained in the photopolymerization composition is in the range described above, preferable results are provided in terms of, for example, the strength of a formed image. The ratio of the content of the photopolymerizable ethylenically unsaturated bond-containing compound to the content of the binder polymer (content of photopolymerizable ethylenically unsaturated bond-containing compound / content of binder polymer) is, as a mass ratio, preferably in the range of from 1/9 to 9/1, more preferably in the range of from 2/8 to 8/2, and even more preferably in the range of from 3/7 to 7/3.

### (Other Components)

The photopolymerization photosensitive composition preferably includes, in addition to the basic components described above, a small amount of a thermal polymerization inhibitor in order to inhibit any unnecessary thermal polymerization of a polymerizable ethylenically unsaturated compound during the production or storage of the photosensitive composition.

The photopolymerization photosensitive composition may further include a colorant for the purpose of coloring the photopolymerization photosensitive composition. Examples of the colorant include pigments such as phthalocyanine pigments (for example, C.I. Pigment Blue 15:3, 15:4, and 15:6 ), azo pigments, carbon black, and titanium oxide, Ethyl Violet, Crystal Violet, azo dyes, anthraquinone dyes, and cyanine dyes.

### [Thermal Polymerization Photosensitive Composition]

Next, the thermal polymerization photosensitive composition is described. A thermal polymerization photosensitive composition usually includes an infrared absorber, a polymerization initiator, an ethylenically unsaturated bond-containing monomer, and a binder polymer.

### (Infrared Absorber)

An infrared absorber has a function of converting absorbed infrared radiation to heat. The polymerization initiator (radical generator) described below is thermally decomposed by the heat generated at this time, and generates a radical. The infrared absorber used in the invention is preferably a dye or pigment having an absorption maximum at a wavelength of from 760 nm to 1200 nm.

Commercially available dyes and known dyes disclosed in, for example, the literature such as *"Senryo-Binran"* (Handbook of Dyes) edited by *Yu-ki Go-sei Kagaku Kyokai* (the Association of Organic Synthetic Chemistry) and published in 1970 may be used as dyes. Specific examples of dyes include azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Preferable dyes include: cyanine dyes disclosed in JP-A Nos. S58-125246, S59-84356, S59-202829, and S60-78787; methine dyes disclosed in JP-ANos. S58-173696, S58-181690, and S58-194595; naphthoquinone dyes disclosed in JP-ANo. S58-112793, S58-224793, S59-48187, S59-73996, S60-52940, and S60-63744; squarylium dyes disclosed in JP-A No. S58-112792; and cyanine dyes disclosed in UK Patent No. 434,875.

Further examples of preferable dyes include: near-infrared absorption sensitizers disclosed in US Patent No. 5,156,938; substituted arylbenzo(thio)pyrylium salts disclosed in US Patent No. 3,881,924; trimethinethiapyrylium salts disclosed in JP-A No. S57-142645 (US Patent No. 4,327,169); pyrylium-based compounds disclosed in JP-A Nos. 58-181051, S58-220143, S59-41363, S59-84248, S59-84249, S59-146063, and S59-146061; cyanine dyes disclosed in JP-A No. S59-216146; pentamethinethiopyrylium salts disclosed in US Patent No. 4,283,475; pyrylium compounds disclosed in JP-B Nos. H05-13514 and H05-19702; and near-infrared absorption dyes disclosed as Formula (I) or (II) in US Patent No. 4,756,993.

Other preferable examples of infrared absorbers include specific indolenine cyanine dyes disclosed in JP-A No. 2002-278057.

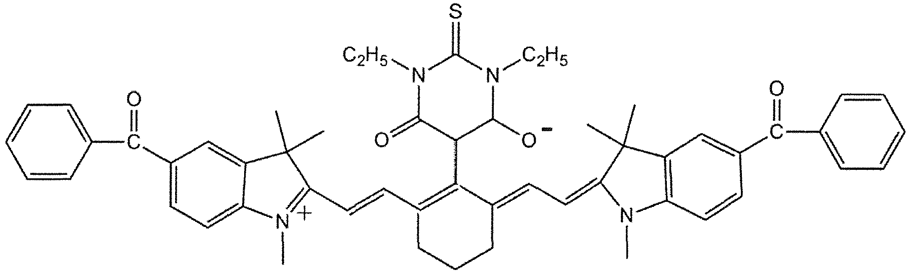

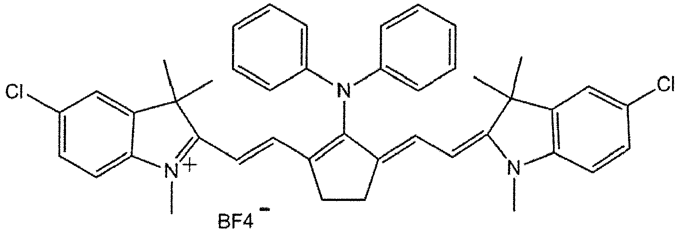

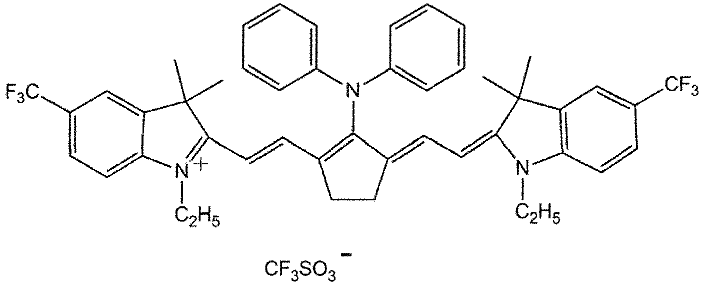

Particularly preferable examples of dyes among these dyes include cyanine dyes, squarylium dyes, pyrylium salts, nickel thiolate complexes, and indolenine cyanine dyes. Cyanine dyes and indolenine cyanine dyes are more preferable, and particularly preferable examples include a cyanine dye represented by the following Formula (a):

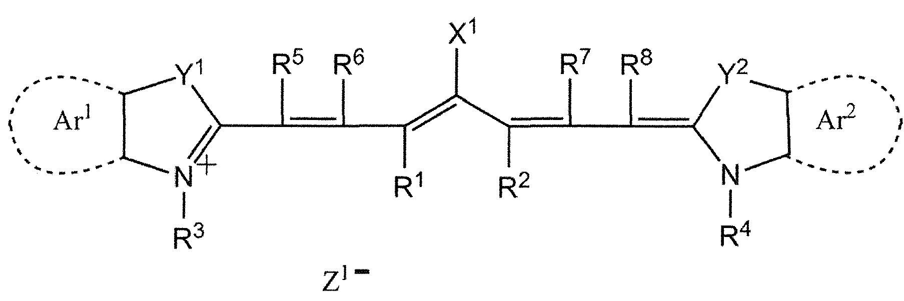

In Formula (a), X¹ represents a hydrogen atom, a halogen atom, -NPh₂, X²-L¹ or a group shown below. X² represents an oxygen atom, a nitrogen atom, or a sulfur atom, and L¹ represents a hydrocarbon group having from 1 to 12 carbon atoms, an aromatic ring having a heteroatom, or a hydrocarbon group having from 1 to 12 carbon atoms and including a heteroatom. Here, the heteroatom refers to N, S, O, a halogen atom, or Se.

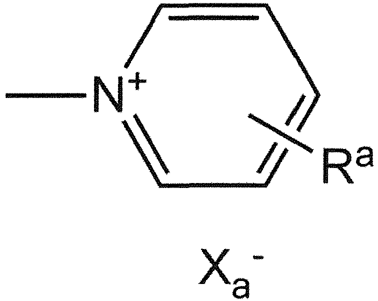

Xa⁻ has the same definition as that of Z¹⁻ described below, and R^{a} represents a substituent selected from the group consisting of a hydrogen atom, an alkyl group, an aryl group, a substituted or unsubstituted amino group, and a halogen atom.

Each of R¹ and R² independently represents a hydrocarbon group having from 1 to 12 carbon atoms. In view of the storage stability of a recording layer coating liquid, each of R¹ and R² is preferably a hydrocarbon group having 2 or more carbon atoms, and it is particularly preferable that R¹ and R² are bonded to each other to form a 5-membered ring or a 6-membered ring.

Ar¹ and Ar² may be the same as or different from each other, and each of Ar¹ and Ar² represents an aromatic hydrocarbon group that may have a substituent. Preferable examples of the aromatic hydrocarbon group include a benzene ring and a naphthalene ring. Preferable examples of the substituent include a hydrocarbon group having 12 or fewer carbon atoms, a halogen atom, and an alkoxy group having 12 or fewer carbon atoms. Y¹ and Y² may be the same as or different from each other, and each of Y¹ and Y² represents a sulfur atom or a dialkylmethylene group having 12 or fewer carbon atoms. R₃ and R₄ may be the same as or different from each other, and each of R³ and R₄ represents a hydrocarbon group having 20 or fewer carbon atoms that may have a substituent. Preferable examples of the substituent include an alkoxy group having 12 or fewer carbon atoms, a carboxy group, and a sulfo group. R⁵, R⁶, R⁷ and R⁸ may be the same as or different from each other, and each of R⁵, R⁶, R⁷ and R⁸ represents a hydrogen atom or a hydrocarbon group having 12 or fewer carbon atoms. In view of availability of the raw material, each of R⁵, R⁶, R⁷ and R⁸ preferably represents a hydrogen atom. Z¹⁻ represents a counter anion. However, when the cyanine dye represented by Formula (a) has an anionic substituent in its structure and neutralization of charge is not necessary, Z¹⁻ may be omitted. In view of the storage stability of a recording layer coating liquid, preferable examples of the counter ion represented by Z¹⁻ include a halogen ion, a perchlorate ion, a tetrafluoroborate ion, a hexafluorophosphate ion, and a sulfonate ion, and particularly preferable examples include a perchlorate ion, a hexafluorophosphate ion, and an arylsulfonate ion.

When a thermal polymerization photosensitive composition is applied to a photosensitive planographic printing plate, the infrared absorber may be added to the same layer as the layer containing other components, or to another layer that is separately provided from the layer containing other components. In a case in which a negative photosensitive planographic printing plate is to be produced and an image recording layer therein includes an infrared absorber, the image recording layer may include the infrared absorber such that the absorbance of the image recording layer at the maximum absorption wavelength in the wavelength region of from 760 nm to 1200 nm is in the range of from 0.5 to 1.2 as measured by a reflection measurement method. The absorbance is preferably in the range of from 0.6 to 1.15.

### (Polymerization Initiator)

The thermal polymerization photosensitive composition preferably includes a sulfonium salt polymerization initiator, which is a thermal-decomposition-type radical generator that is decomposed by heat to generate a radical, as a polymerization initiator for initiating and advancing a curing reaction of the after-mentioned polymerizable compound. In the invention, in a case in which a sulfonium salt polymerization initiator is used in combination with the infrared absorber described above, the infrared absorber emits heat when irradiated with an infrared laser, and the heat enables the sulfonium salt polymerization initiator to generate a radical. In the invention, since high sensitivity heat mode recording is enabled by a combination of the sulfonium salt polymerization initiator and the infrared absorber, this combination is preferable.

Examples of the sulfonium salt polymerization initiator that can be suitably used in the invention include an onium salt represented by the following Formula (I):

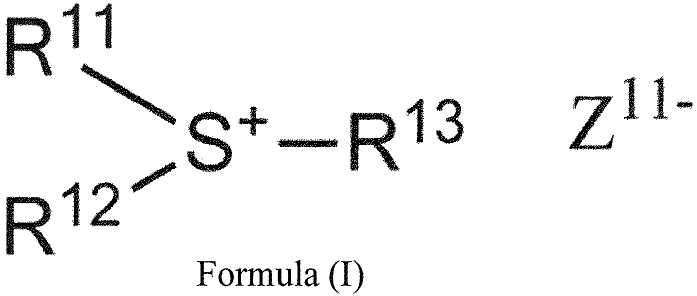

In Formula (I), R¹¹, R¹² and R¹³ may be the same as each other or different from each other, and each of R¹¹, R¹² and R¹³ represents a hydrocarbon group having 20 or fewer carbon atoms that may have a substituent. Preferable examples of the substituent include a halogen atom, a nitro group, an alkyl group having 12 or fewer carbon atoms, an alkoxy group having 12 or fewer carbon atoms, and an aryloxy group having 12 or fewer carbon atoms. Z¹¹⁻ represents a counter ion selected from the group consisting of a halogen ion, a perchlorate ion, a tetrafluoroborate ion, a hexafluorophosphate ion, a carboxylate ion, and a sulfonate ion, and preferably represents a perchlorate ion, a hexafluorophosphate ion, a carboxylate ion, or an arylsulfonate ion.

Specific examples of the onium salt represented by Formula (I) include compounds [OS-1] to [OS-10] disclosed in JP-A No. 2006-220931, but the examples are not limited to thereto.

In addition to those described above, specific aromatic sulfonium salts disclosed in JP-A Nos. 2002-148790, 2002-148790, 2002-350207, and 2002-6482 are also suitable for use.

In the invention, an initiator other than the sulfonium salt polymerization initiator is also usable. In particular, another polymerization initiator (another radical generator) may be used in combination with the sulfonium salt polymerization initiator.

Examples of the another radical generator include onium salt other than sulfonium salts, triazine compounds having a trihalomethyl group, peroxides, azo-based polymerization initiators, azide compounds, quinone diazide, oxime ester compounds, and triaryl monoalkyl borate compounds. Among these, onium salts are preferable due to high sensitivity thereof.

Examples of onium salts other than sulfonium salts, which can suitably be used in the invention, include iodonium salts and diazonium salts. In the invention, these onium salts function not as acid generators, but as radical polymerization initiators.

Examples of onium salts, other than sulfonium salts, in the invention also include onium salts represented by the following Formula (II) and onium salts represented by the following Formula (III):

Ar²¹-I⁺-Ar²² Z²¹⁻ Formula (II)

Ar³¹-N⁺≡N Z³¹⁻ Formula (III)

In Formula (II), each of Ar²¹ and Ar²² independently represents an aryl group having 20 or fewer carbon atoms that may have a substituent. Preferable examples of the substituent in a case in which this aryl group has a substituent include a halogen atom, a nitro group, an alkyl group having 12 or fewer carbon atoms, an alkoxy group having 12 or fewer carbon atoms, and an aryloxy group having 12 or fewer carbon atoms. Z²¹⁻ represents a counter ion having the same definition as that of Z¹¹⁻ in Formula (I), and preferable examples thereof are also the same.

In Formula (III), Ar³¹ represents an aryl group having 20 or fewer carbon atoms that may have a substituent. Preferable examples of the substituent include a halogen atom, a nitro group, an alkyl group having 12 or fewer carbon atoms, an alkoxy group having 12 or fewer carbon atoms, an aryloxy group having 12 or fewer carbon atoms, an alkylamino group having 12 or fewer carbon atoms, a dialkylamino group having 12 or fewer carbon atoms, an arylamino group having 12 or fewer carbon atoms, and a diarylamino group having 12 or fewer carbon atoms. Z³¹⁻ represents a counter ion having the same definition as that of Z¹¹⁻ in Formula (I), and preferable examples thereof are also the same.

Examples of the onium salt represented by Formula (II) and the onium salt represented by Formula (III) that can be suitably used in the invention include compounds [OI-1] to [OI-10] and [ON-1] to [ON-5] disclosed in JP-ANo. 2006-220931. However, the examples are not limited thereto.

Specific examples of the onium salt that can be suitably used as a polymerization initiator (radical generator) include those disclosed in JP-ANo. 2001-133696.

In addition, the maximum absorption wavelength of the polymerization initiator (radical generator) is preferably 400 nm or less, and more preferably 360 nm or less. When the absorption wavelength is set to the ultraviolet region as described above, handling of the photosensitive planographic printing plate can be carried out under a white light.

The total content of polymerization initiators in the thermal polymerization photosensitive composition may be adjusted to be in the range of from 0.1% by mass to 50% by mass, preferably 0.5% by mass to 30% by mass, and particularly preferably 1% by mass to 20% by mass, with respect to the total solid content of the thermal polymerization photosensitive composition. When the total content of the polymerization initiator is 0.1% by mass or more with respect to the total solid content, favorable sensitivity can be obtained. When the total content is 50% by mass or less, blemish does not occur in non-image areas at the time of printing in a case in which the thermal polymerization photosensitive composition is applied to a photosensitive planographic printing plate.

The thermal polymerization photosensitive composition particularly preferably includes a sulfonium salt polymerization initiator as a polymerization initiator, in which case only one sulfonium salt polymerization initiator may be used singly, or two or more polymerization initiators (at least one of which is a sulfonium salt polymerization initiator) may be used in combination. When two or more polymerization initiators are used in combination, the two or more polymerization initiators to be used may include only sulfnoium salt polymerization initiators, or include a sulfonium salt polymerization initiator and another polymerization initiator in combination.

The content ratio (mass ratio) in the case of using a sulfonium salt polymerization initiator and another polymerization initiator in combination, the ratio of the content of sulfonium salt polymerization initiator to the content of other polymerization initiator is preferably in the range of from 100/1 to 100/50, and more preferably in the range of from 100/5 to 100/25.

### (Polymerizable Compound)

The polymerizable compound used in the thermal polymerization photosensitive composition is an addition-polymerizable compound having at least one ethylenically unsaturated double bond, and is selected from compounds that has at least one ethylenically unsaturated bond, and preferably has two or more ethylenically unsaturated bonds. This class of compounds are widely known in the pertinent industrial field, and, in the invention, these compounds can be used without any particular limitations. These compounds have a chemical form, for example, a monomer, a prepolymer (namely, a dimer, a trimer, or an oligomer), a mixture thereof, or a copolymer thereof. Examples of the monomer and copolymers thereof include unsaturated carboxylic acids (for example, acrylic acid, methacrylic acid, itaconic acid, crotonic acid, isocrotonic acid, and maleic acid), and esters and amides thereof. Preferably, an ester of an unsaturated carboxylic acid and an aliphatic polyhydric alcohol compound, or an amide of an unsaturated carboxylic acid and an aliphatic polyvalent amine compound, is used. An addition reaction product between an unsaturated carboxylic acid ester or amide having a nucleophilic substituent such as a hydroxyl group, an amino group or a mercapto group and a monofunctional or polyfunctional isocyanate compound or epoxy compound, and a dehydration condensation reaction product between the unsaturated carboxylic acid ester or amide and a monofunctional or polyfunctional carboxylic acid, are also suitable for use. An addition reaction product between an unsaturated carboxylic acid ester or amide having an electrophilic substituent such as an isocyanate group or an epoxy group and a monofunctional or polyfunctional alcohol, amine or thiol, and a substitution reaction product between an unsaturated carboxylic acid ester or amide having a leaving substituent such as a halogen group or a tosyloxy group and a monofunctional or polyfunctional alcohol, amine or thiol, are also favorable. A class of compounds, each of which is obtained by replacing an unsaturated carboxylic acid in any of the polymerizable compounds described above with unsaturated phosphonic acid, styrene, vinyl ether, or the like, are also usable.

Specific examples of the polymerizable compound include the above-described polymerizable compounds that can be used as ethylenically unsaturated bond-containing compounds usable in the photopolymerization photosensitive composition, and that are described in the above explanation of the photopolymerization photosensitive composition.

Other examples of esters that can be suitably used as polymerizable compounds include: aliphatic alcohol esters disclosed in JP-B Nos. S46-27926 and S51-47334, and JP-A No. S57-196231; compounds having an aromatic skeleton disclosed in JP-A Nos. S59-5240, S59-5241, and H02-226149; and compounds having an amino group disclosed in JP-A No. H01-165613. The ester monomers described above may also be used in the form of a mixture.

### (Binder Polymer)

The binder polymer used in the thermal polymerization photosensitive composition is contained in the thermal polymerization photosensitive composition from the viewpoint of improving film properties, and various binder polymers may be used as long as they have a function of improving film properties. Among them, examples of suitable binder polymers that can be used in the thermal polymerization photosensitive composition in the invention include a binder polymer having a repeating unit represented by the following Formula (i). Hereinafter, this polymer shall also be referred to as the "specific binder polymer", and is described below in detail.

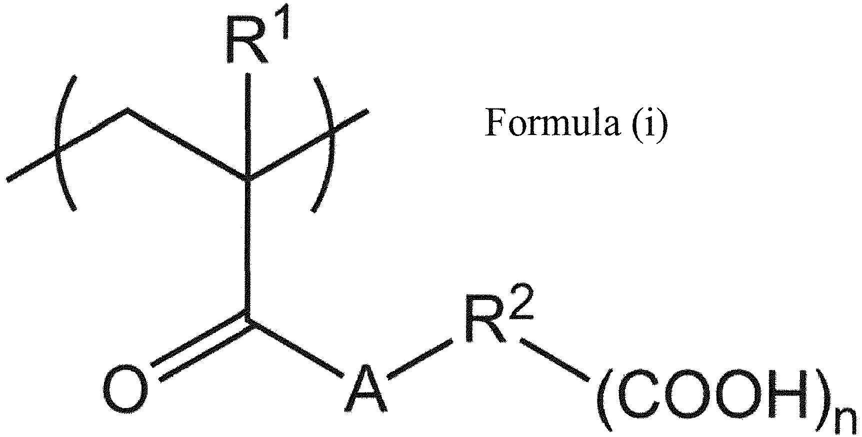

In the formula, R¹ represents a hydrogen atom or a methyl group; R² represents a linking group; A represents an oxygen atom or NR³-; R³ represents a hydrogen atom or a monovalent hydrocarbon group having from 1 to 10 carbon atoms; and n represents an integer from 1 to 5.

The linking group represented by R² in Formula (i) may be a linking group which is formed of an atom or an atomic group selected from the group consisting of hydrogen atoms, oxygen atoms, nitrogen atoms, sulfur atoms, and halogen atoms, and in which the number of atoms, excluding the atoms of any substituents, is from 2 to 30. Specific examples thereof include alkylenes, substituted alkylenes, arylenes, substituted arylenes, and structures each obtained by linking two or more divalent groups selected from these via amide bond(s) and/or ester bond(s).

When the linking group represented by R² has a chain structure, examples of the linking group having the chain structure include ethylene and propylene. A structure obtained by linking plural alkylene units, such as those described above, via ester bond(s) is also an example of a preferable linking group.

Among these, the linking group represented by R² in Formula (i) is preferably a hydrocarbon group having a valency of (n+1) and having an aliphatic cyclic structure having from 3 to 30 carbon atoms. More specific examples thereof include a hydrocarbon group that has a valency of (n+1) and that is obtained by eliminating (n+1) hydrogen atoms located on at least one arbitrary-selected carbon atom in a compound having an aliphatic cyclic structure, such as cyclopropane, cyclopentane, cyclohexane, cycloheptane, cyclooctane, cyclodecane, dicyclohexyl, tercyclohexyl, or norbornane, each of which may be substituted by one or more freely-selected substituents. R² preferably has 3 to 30 carbon atoms, including the carbon atoms of any substituents.

Any of the carbon atoms in a compound forming an aliphatic cyclic structure may be substituted by one or more heteroatoms selected from the group consisting of a nitrogen atom, an oxygen atom, and a sulfur atom. From the viewpoint of printing durability, R² is preferably a hydrocarbon group having a valency of (n+1) and having an aliphatic cyclic structure that includes two or more rings, that has from 5 to 30 carbon atoms, and that may have a substituent, such as a fused polycyclic aliphatic hydrocarbon, a bridged ring aliphatic hydrocarbon, a spiro-aliphatic hydrocarbon, or an aliphatic hydrocarbon ring assembly (structure composed of plural rings linked by bond(s) and/or linking group(s)). Also in this case, the number of carbon atoms refers to the total number of carbon atoms including the carbon atoms of any substituents.

The linking group represented by R² is more preferably a linking group having from 5 to 10 carbon atoms. The structure of the linking group represented by R² is preferably a chain structure having an ester bond in its structure, or a chain structure having a cyclic structure, such as those described above, in its structure.

Examples of substituents that can be introduced into the linking group represented by R² include monovalent non-metal atomic groups other than a hydrogen atom, and more specific examples thereof include halogen atoms (-F, -Br, -Cl and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group and a conjugated base group thereof, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugated base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugated base group thereof, an N-alkylsulfonylsulfamoyl group (-SO₂NHSO₂(alkyl)) and a conjugated base group thereof, an N-arylsulfonylsulfamoyl group (-SO₂NHSO₂(aryl)) and a conjugated base group thereof, an N-alkylsulfonylcarbamoyl group (-CONHSO₂(alkyl)) and a conjugated base group thereof, an N-arylsulfonylcarbamoyl group (-CONHSO₂(aryl)) and a conjugated base group thereof, an alkoxysilyl group (-Si(Oalkyl)₃), an aryloxysilyl group (-Si(Oaryl)₃), a hydroxysilyl group (-Si(OH)₃) and a conjugated base group thereof, a phosphono group (-PO₃H₂) and a conjugated base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugated base group thereof, a monoarylphosphono group (-PO₃H(aryl)) and a conjugated base group thereof, a phosphonooxy group (-OPO₃H₂) and a conjugated base group thereof, a dialkylphosphonooxy group (-OPO₃(alkyl)₂), a diarylphosphooxy group (-OPO₃(aryl)₂), an alkylarylphosphonooxy group (-OPO₃(alkyl)(aryl)), a monoalkylphosphonooxy group (-OPO₃H(alkyl)) and a conjugated base group thereof, a monoarylphosphonooxy group (-OPO₃H(aryl)) and a conjugated base group thereof, a cyano group, a nitro group, a dialkylboryl group (-B(alkyl)₂), a diarylboryl group (-B(aryl)₂), an alkylarylboryl group (-B(alkyl)(aryl)), a dihydroxyboryl group (-B(OH)₂) and a conjugated base group thereof, an alkylhydroxyboryl group (-B(alkyl)(OH)) and a conjugated base group thereof, an arylhydroxyboryl group (-B(aryl)(OH)) and a conjugated base group thereof, an aryl group, an alkenyl group, and an alkynyl group.

When the thermal polymerization photosensitive composition is applied to a photosensitive planographic printing plate, there is a tendency that substituents having a hydrogen atom capable of hydrogen bonding and, particularly, substituents having acidity of which the acid dissociation constant (pKa) is smaller than that of carboxylic acid decrease printing durability, though depending on the design of the image recording layer. Therefore, these substituents are not preferable as substituents to be introduced into the linking group represented by R². In contrast, hydrophobic substituents such as halogen atoms, hydrocarbon groups (for example, alkyl groups, aryl groups, alkenyl groups, and alkynyl groups), alkoxy groups, and aryloxy groups are more preferable due to their tendency to increase printing durability. In particular, when the cyclic structure included in the linking group represented by R² is a monocyclic aliphatic hydrocarbon having a 6- or fewer-membered ring such as cyclopentane or cyclohexane, the linking group represented by R² preferably has a hydrophobic substituent such as those listed above. Two or more substituents on the linking group represented by R² may be bonded to each other, if possible, to form a ring. A substituent on the linking group represented by R² may be bonded to the hydrocarbon group on which the substituent is located, to form a ring. Further, a substituent on the linking group represented by R² may be itself be substituted.

When A in Formula (i) is NR³-, R³ represents a hydrogen atom or a monovalent hydrocarbon group having from 1 to 10 carbon atoms. Examples of the monovalent hydrocarbon group having from 1 to 10 carbon atoms and represented by R³ include an alkyl group, an aryl group, an alkenyl group, and an alkynyl group. Specific examples of the alkyl group include straight-chain, branched-chain or cyclic alkyl groups having from 1 to 10 carbon atoms, such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group, and a 2-norbornyl group.

Specific examples of the aryl group include: aryl groups having from 1 to 10 carbon atoms, such as a phenyl group, a naphthyl group, and an indenyl group; and heteroaryl groups having from 1 to 10 carbon atoms and including one heteroatom selected from the group consisting of a nitrogen atom, an oxygen atom and a sulfur atom. Examples thereof include a furyl group, a thienyl group, a pyrrolyl group, a pyridyl group, and a quinolyl group.

Specific examples of the alkenyl group include straight-chain, branched-chain or cyclic alkenyl groups having from 1 to 10 carbon atoms, such as a vinyl group, a 1-propenyl group, a 1-butenyl group, a 1-methyl-1-propenyl group, a 1-cyclopentenyl group, and a 1-cyclohexenyl group.

Specific examples of the alkynyl group include alkynyl groups having from 1 to 10 carbon atoms, such as an ethynyl group, a 1-propynyl group, a 1-butynyl group and a 1-octynyl group. Examples of a substituent that R³ may have are the same as those described above as examples of a substituent that can be introduced into R². However, the number of carbon atoms of the hydrocarbon group represented by R³ is from 1 to 10, including the number of carbon atoms of any substituents. A in Formula (i) is preferably an oxygen atom or -NH-, from the viewpoint of ease of synthesis.

In Formula (i), n represents an integer from 1 to 5, and is preferably 1 from the viewpoint of printing durability.

Preferable specific examples of the repeating unit represented by Formula (i) include specific examples disclosed in paragraphs [0134] to [0143] of JP-A No. 2006-220931. However, the invention is not limited to thereto.

The binder polymer may include only one type of repeating unit represented by Formula (i), or two or more types of repeating units represented by Formula (i). The specific binder polymer that can be used in the thermal polymerization photosensitive composition in the invention may be a polymer composed only of repeating units represented by Formula (i). However, usually, repeating units represented by Formula (i) are combined with other copolymer components, and used as a copolymer. The total content of repeating units represented by Formula (i) in the copolymer may be appropriately determined in consideration of, for example, the structure thereof and design of the composition. The total content of repeating units represented by Formula (i) contained in the copolymer is preferably in the range of from 1 mol% to 99 mol%, more preferably 5 mol% to 40 mol%, and even more preferably 5 mol% to 20 mol%, with respect to the total molar amount of the components of the polymer.

In a case in which the specific binder polymer is a copolymer, any conventionally known radical-polymerizable monomer may be used, without any limitations, as a copolymer component other than the repeating unit represented by Formula (i). Specific examples include the monomers disclosed in *"*Ko-bunshi Data Handbook" (Polymer Data Handbook) - Fundamentals - edited by the Society of Polymer Science, Japan (Baifukan Co., Ltd., 1986). These copolymer components may be used singly, or two or more thereof may be used in combination.

The molecular weight of the specific binder polymer in the invention is appropriately determined from the viewpoint of image forming properties, or printing durability of the planographic printing plate. Usually, when the molecular weight increases, excellent printing durability is obtained, but image forming properties tend to deteriorate. On the contrary, when the molecular weight is small, image forming properties are improved, but printing durability is lowered. The molecular weight of the specific binder polymer is preferably in the range of from 2,000 to 1,000,000, more preferably in the range of from 5,000 to 500,000, and even more preferably in the range of from 10,000 to 200,000.

The binder polymer used in the thermal polymerization photosensitive composition in the invention may include only the specific binder polymer, or may include one or more other binder polymers in addition to the specific binder polymer so as to be used as a mixture. The one or more binder polymers that may be additionally used may be used at a proportion in the range of from 1% by mass to 60% by mass, preferably 1% by mass to 40% by mass, and even more preferably 1% by mass to 20% by mass, with respect to the total mass of binder polymer components. Conventionally known binder polymers may be used, without any limitations, as binder polymers that may additionally be used. Specifically, binders having acrylic main chains, urethane binders, and the like that are frequently used in the relevant technical field are preferable.

The total amount of the specific binder polymer and the additionally-employable binder polymers in the thermal polymerization photosensitive composition may be decided, as appropriate. The ratio of the total amount of the specific binder polymer and the additionally-employable binder polymers in the thermal polymerization photosensitive composition relative to the total mass of non-volatile components in the composition is usually in the range of from 10% by mass to 90% by mass, preferably 20% by mass to 80% by mass, and even more preferably 30% by mass to 70% by mass.

The acid value (meq/g) of the binder polymer is preferably in the range of from 2.00 to 3.60.

### (Additionally-employable Other Binder Polymers)

Another binder polymer that can be used in combination with the specific binder polymer is preferably a binder polymer having a radical polymerizable group. The radical polymerizable group is not particularly limited as long as the group can polymerize via a radical, and examples thereof include an α-substituted methylacrylic group [-OC(=O)-C(-CH₂Z)=CH₂, wherein Z represents a hydrocarbon group starting from a heteroatom], an acrylic group, a methacrylic group, an allyl group and a styryl group. Among these, an acrylic group and a methacrylic group are preferable.

Another binder polymer that can additionally be used preferably further has an alkali-soluble group. The content of alkali-soluble groups in the binder polymer (acid value as determined by neutralization titration) is preferably 0.1 mmol to 3.0 mmol, more preferably 0.2 mmol to 2.0 mmol, and most preferably 0.45 mmol to 1.0 mmol, per gram of the binder polymer. When the content of alkali-soluble groups is smaller than 0.1 mmol, there are cases in which the binder polymer precipitates in development, thereby generating development residues. When the content of alkali-soluble groups is greater than 3.0 mmol, there are cases in which the binder polymer has excessively high hydrophilicity, thereby decreasing the printing durability when the composition is applied to a planographic printing plate.

The photosensitive composition may include, as appropriate, other components suitable for the use, production method, and the like of the composition, in addition to the basic components described above. Examples of preferable additives are described below.

### (Polymerization Inhibitor)

In the invention, the photosensitive composition preferably includes a small amount of a thermal polymerization inhibitor in order to inhibit any unnecessary thermal polymerization of a compound having a polymerizable ethylenically unsaturated double bond, i.e., a polymerizable compound. Examples of appropriate thermal polymerization inhibitors include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitrosophenylhydroxyamine cerous salt. The content of thermal polymerization initiator is preferably in the range of from about 0.01% by mass to about 5% by mass with respect to the mass of non-volatile components in the entire composition. In accordance with the necessity, a higher fatty acid derivative such as behenic acid or behenic acid amide may be added to the photosensitive composition, and allowed to localize at the surface of the image recording layer during a drying process after coating, with a view to preventing polymerization from being inhibited by oxygen. The content of higher fatty acid derivative is preferably in the range of from about 0.5% by mass to about 10% by mass with respect to non-volatile components in the entire composition.

### (Colorant)

The photosensitive composition may include a dye or a pigment for the purpose of coloration thereof. When a printing plate is produced using the photosensitive composition, the inclusion of a dye or a pigment enables improvement in visibility after plate-making or so-called plate-checking properties such as suitability for image density measuring devices. Since many dyes cause a decrease in sensitivity of a layer formed from the photopolymerization photosensitive composition (image recording layer), it is particularly preferable to use a pigment as the colorant. Specific examples of the colorant include pigments such as phthalocyanine pigments, azo pigments, carbon black, and titanium oxide, and dyes such as Ethyl Violet, Crystal Violet, azo dyes, anthraquinone dyes, and cyanine dyes. The content of dye and pigment as colorants is preferably in the range of from about 0.5% by mass to about 5% by mass with respect to non-volatile components in the entire composition.

### (Other Additives)

The photosensitive composition may further include a known additive such as an inorganic filler for improving the properties of a cured film, a plasticizer, or a sensitizing agent capable of enhancing ink receptivity of a surface of the image recording layer. Examples of the plasticizer include dioctyl phthalate, didodecyl phthalate, triethylene glycol dicaprylate, dimethyl glycol phthalate, tricresyl phosphate, dioctyl adipate, dibutyl sebacate, and triacetylglycerin. The plasticizer may be contained in the photosensitive composition in an amount in the range of, generally, 10% by mass or less with respect to the total mass of binder polymers and addition-polymerizable compounds. The photosensitive composition may include a UV initiator, a thermal crosslinking agent, or the like, for enhancing the effects exerted by heating and light exposure after development, which aims to enhance the film strength (printing durability) in the photosensitive planographic printing plate described below.

The thermal polymerization or photopolymerization photosensitive composition described above can suitably be used as an image recording layer in the photosensitive planographic printing plate described below.

### [Photosensitive Planographic Printing Plate]

The photosensitive planographic printing plate has a configuration in which an image recording layer and, optionally, a protective layer are sequentially provided on a support, and the image recording layer includes the photosensitive composition described above. This photosensitive planographic printing plate can be produced by applying an image recording layer coating liquid that includes the photosensitive composition described above to an appropriate support or to an intermediate layer provided on a support, or applying the photosensitive coating liquid and a coating liquid obtained by dissolving coating liquid components for a desired layer such as a protective layer in a solvent to an appropriate support or an intermediate layer provided on a support.

### [Image Recording Layer]

The image recording layer is a negative image recording layer that includes the photosensitive composition described above, particularly the photopolymerization photosensitive composition or the thermal polymerization photosensitive composition. A photopolymerization or thermal polymerization negative image recording layer of this type has a mechanism in which a polymerization initiator is decomposed by light or heat to generate a radical and the generated radical causes a polymerizable compound to undergo a polymerization reaction. The photosensitive planographic printing plate having an image recording layer of this type has features that the photosensitive planographic printing plate is particularly suitable for plate-making by direct drawing with laser light having a wavelength of 300 nm to 1,200 nm, and that the photosensitive planographic printing plate exhibits high printing durability and high image forming properties, compared to conventional photosensitive planographic printing plates.

The coating amount of the image recording layer can affect mainly the sensitivity and developability of the image recording layer and the strength and printing durability of an light-exposed film, the coating amount is preferably selected, as appropriate, in accordance with the use. When the coating amount is too small, printing durability becomes insufficient. When the coating amount is too large, sensitivity decreases, exposure to light takes a long time, and a longer time is required for development; thus an excessively large coating amount is not favorable. In the case of a photosensitive planographic printing plate for scanning exposure to light, which is a major object of the invention, a coating amount, in terms of mass after drying, of the image recording layer in the range of from about 0.1 g/m² to about 10 g/m² is appropriate, and a coating amount, in terms of mass after drying, of the image recording layer in the range of from 0.5 g/m² to 5 g/m² is more preferable.

### [Support]

The support for the photosensitive planographic printing plate according to the invention is an aluminum support having a hydrophilic surface.

An aluminum plate is a dimensionally stable metal plate that includes aluminum as a main component, and may be a pure aluminum plate or an alloy plate that includes aluminum as a main component and trace amounts of other elements. In the following descriptions, the substrate formed of aluminum or an aluminum alloy described above shall generally be referred to as an aluminum substrate or an aluminum plate. Examples of other elements contained in the aluminum alloy include silicon, iron, manganese, copper, magnesium, chromium, zinc, bismuth, nickel, and titanium, and the content ratio of other elements in the alloy is 10% by mass or less. In the invention, a pure aluminum plate is preferable. However, since it is difficult to produce perfectly pure aluminum in terms of refining technology, aluminum plates that include a slight amount of other elements are also usable. As described above, the composition of the aluminum plate applied to the invention is not limited to a specific composition, and conventionally known and used materials, for example, JIS A 1050, JIS A 1100, JIS A 3103, and JIS A 3005, may be used, as appropriate.

The thickness of the aluminum substrate used in the invention is from about 0.1 mm to about 0.6 mm. This thickness may be changed, as appropriate, in accordance with the size of the printing machine, the size of the printing plate, and the requests from the user. The aluminum substrate may be subjected, as appropriate, to the substrate surface treatment described below in accordance with the necessity.

### (Surface Roughening Treatment)

Examples of methods for surface roughening treatment include mechanical surface roughening, chemical etching, and electrolytic graining, such as those disclosed in JP-A No. S56-28893. For example, an electrochemical surface roughening method that includes electrochemically roughening a surface in a hydrochloric acid electrolytic solution or a nitric acid electrolytic solution, and mechanical surface roughening methods such as a wire brush graining method that includes scratching an aluminum surface with metal wires, a pole graining method that includes graining an aluminum surface with abrasive balls and an abrasive, and a brush graining method that includes roughening a surface with a nylon brush and an abrasive, may be used. The surface roughening methods described above may be used singly, or in combination of two or more thereof. Among them, a method useful as a method used for surface roughening is an electrochemical method that includes chemically roughening a surface in a hydrochloric acid electrolytic solution or a nitric acid electrolytic solution, and a preferable anode-time quantity of electricity is in the range of from 50 C/dm² to 400 C/dm². More specifically, it is preferable to carry out alternating-current and/or direct-current electrolysis in an electrolytic solution that includes from 0.1% to 50% hydrochloric acid or nitric acid under the conditions with a temperature of 20°C to 80°C, a duration of 1 second to 30 minutes, and a current density of from 100 C/dm² to 400 C/dm².

An aluminum substrate that has been surface-roughened in this matter may be chemically etched using an acid or an alkali. Examples of etching agents that can be suitably used include caustic soda, sodium carbonate, sodium aluminate, sodium metasilicate, sodium phosphate, potassium hydroxide, and lithium hydroxide, and the preferable ranges of concentration and temperature are from 1% to 50%, and from 20°C to 100°C, respectively. In order to eliminate contamination (smut) remaining on a surface after etching, acid washing is carried out. Here, nitric acid, sulfuric acid, phosphoric acid, chromic acid, hydrofluoric acid, and hydrofluoroboric acid. In particular, preferable examples of methods for removing smut after electrochemical surface roughening treatment include a method involving contact with from 15% by mass to 65% by mass sulfuric acid at a temperature of 50°C to 90°C, such as that disclosed in JP-A No. S53-12739, and a method including performing alkali etching, such as that disclosed in JP-B No. S48-28123. When the center line average roughness Ra of the treated surface of an aluminum substrate after being treated as described above is from 0.2 µm to 0.5 µm, methods and conditions for the surface treatment are not particularly limited.

### (Anodization Treatment)

The aluminum substrate on which an oxide layer has been formed through treatment as described above is subsequently subjected to anodization treatment.

In the anodization treatment, an aqueous solution of sulfuric acid, phosphoric acid, oxalic acid, or boric acid/sodium borate may be used singly as a main component of the electrolytic bath, or a combination of two or more of an aqueous solution of sulfuric acid, an aqueous solution of phosphoric acid, an aqueous solution of oxalic acid, or an aqueous solution of boric acid/sodium borate may be used as a main component of the electrolytic bath. Naturally, components usually contained in at least an Al alloy plate, an electrode, tap water, underground water, and the like may be contained in the electrolytic solution. A second component and a third component may also be incorporated into the electrolytic solution. Examples of the second component and the third component mentioned above include: cationic ions, for example, ions of metals such as Na, K, Mg, Li, Ca, Ti, Al, V, Cr, Mn, Fe, Co, Ni, Cu and Zn, and ammonium ions; and anions, for example, nitrate ion, carbonate ion, chlorate ion, phosphate ion, fluorine ion, sulfite ion, titanate ion, silicate ion, and borate ion. The concentration thereof in the electrolytic solution may be from about 0 ppm to about 10,000 ppm. There are no particular limitations on the conditions of the anodization treatment. The anodization treatment is preferably carried out through direct current or alternating current electrolysis in the ranges of an amount of from 30 g/liter to 500 g/liter, a temperature of the treatment liquid of from 10°C to 70°C, and an electric current density of from 0.1 A/m² to 40 A/m². The thickness of the formed anodized film is in the range of from 0.5 µm to 1.5 µm, and preferably in the range of from 0.5 µm to 1.0 µm. The treatment conditions may be selected such that the micropores present in the anodized film on the support produced through the above-described treatment has a pore size in the range of from 5 nm to 10 nm and a pore density in the range of from 8×10¹⁵/m² to 2×10¹⁶/m².

Known methods can widely be applied as hydrophilicity-imparting treatment for a support surface. Particularly preferable treatment is hydrophilicity-imparting treatment using a silicate, polyvinylphosphonic acid, or the like. A film is formed in a coating amount that provides an amount of Si or P element of preferably from 2 mg/m² to 40 mg/m², more preferably from 4 mg/m² to 30 mg/m². The coating amount can be measured by a fluorescent X-ray analysis method.

The hydrophilicity-imparting treatment described above is carried out by immersing an aluminum substrate, on which an anodized film is formed, in an aqueous solution at from 15°C to 80°C for from 0.5 seconds to 120 seconds, the aqueous solution having a pH at 25°C of from 10 to 13, and including alkali metal silicate or polyvinylphosphonic acid in an amount of preferably from 1% by mass to 30% by mass, more preferably from 2% by mass to 15% by mass.

The photosensitive planographic printing plate may be provided with an intermediate layer for the purpose of improving the adhesiveness between the image recording layer and the support, or soiling characteristics. Specific examples of the intermediate layer include those disclosed in the following patent publications or patent specifications: JP-B No. S50-7481, JP-A Nos. S54-72104, S59-101651, S60-149491, S60-232998, H03-56177, H04-282637, H05-16558, H05-246171, H07-159983, H07-314937, H08-202025, H08-320551, H09-34104, H09-236911, H09-269593, H10-69092, H10-115931, H10-161317, H10-260536, H10-282682, H11-84674, H11-38635, H11-38629, H10-282645, H10-301262, H11-327152, 2000-10292, 2000-235254, 2000-352824, and 2001-209170.

### [Protective Layer (Overcoat Layer)]

It is preferable to provide a protective layer on the image recording layer described above. The protective layer prevents low-molecular-weight compounds, such as oxygen present in the air or basic substances, that inhibit an image forming reaction in the image recording layer caused by exposure to light, from entering into the image recording layer, and the protective layer thereby enables exposure to light in the air. The protective layer is provided basically in order to protect the image recording layer; however, when the image recording layer has a radical polymerization image forming mechanism, the protective layer plays a role as an oxygen blocking layer, and, when exposure to light is performed using a high-illuminance infrared laser, the protective layer performs the function as an ablation preventing layer.

The protective layer is desired to have the characteristics described above, and, moreover, it is preferable that the protective layer does not substantially inhibit transmission of light used for light exposure, has excellent adhesiveness to the image recording layer, and is capable of being easily removed in the development process after light exposure. Designing of the protective layer, such as those described above, have been made from the past, and are disclosed in detail in US Patent No. 3,458,311 and JP-B No. S55-49729.

Water-soluble high-molecular-weight compounds having relatively excellent crystallinity are preferable as materials that can be used in the protective layer, and specific examples thereof include water-soluble polymers such as polyvinyl alcohol, a vinyl alcohol/vinyl phthalate copolymer, a vinyl acetate/vinyl alcohol/vinyl phthalate copolymer, a vinyl acetate/crotonic acid copolymer, polyvinylpyrrolidone, acidic celluloses, gelatin, gum arabic, polyacrylic acid, and polyacrylamide. These may be used singly or in mixture. Among these, when polyvinyl alcohol is used as a main component, the most satisfactory results are obtained from the viewpoint of basic characteristics such as oxygen blocking properties and removability by development.

As long as a polyvinyl alcohol used in the protective layer includes an unsubstituted vinyl alcohol unit for providing the requisite oxygen blocking properties and water solubility, a part of the polyvinyl alcohol may be substituted with one or more selected from the group consisting of an ester, an ether, and an acetal. Similarly, a part of the polyvinyl alcohol may include another copolymer component.

A specific example of polyvinyl alcohol is a polyvinyl alcohol that is hydrolyzed to a degree of 71 % to 100%, and that includes from 300 to 2400 repeating units. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 manufactured by Kuraray Co., Ltd.

In the invention, a planographic printing plate can be produced from a photosensitive planographic printing plate (precursor) by a method that includes at least an imagewise light exposure process, a development process, and a water-washing process.

### [Light Exposure Process for Thermal Polymerization Photosensitive Planographic Printing Plate]

A preferable example of a light source used in the light exposure process of a thermal polymerization photosensitive planographic printing plate in the plate-making method according to the invention is an infrared laser. Thermal recording using an ultraviolet lamp or a thermal head is also possible.

Among others, it is preferable to imagewise expose the image recording layer to light using a solid laser or semiconductor laser that emits infrared light having a wavelength in the range of from 750 nm to 1400 nm. The power output of the laser is preferably 100 mW or more, and, in order to shorten the light exposure time, it is preferable to use a multibeam laser device. The light exposure time per pixel is preferably 20 µsec or less. The amount of energy with which the photosensitive planographic printing plate is irradiated is preferably in the range of from 10 mJ/cm² to 300 mJ/cm². An amount of light exposure energy of 10 mJ/cm² or more is more preferable from the viewpoint of sufficiently advancing the curing of the image recording layer. An amount of light exposure energy of 300 mJ/cm² or less makes it difficult for laser ablation of the image recording layer to occur, and is more preferable in terms of preventing any damage to an image caused by laser ablation.

In the light exposure process, exposure to light may be performed with overlap of light beams from a light source. The overlap means that the sub-scanning pitch is smaller than the beam diameter. When the beam diameter is indicated by the full width at half maximum (FWHM) of the beam intensity, for example, the overlap can be quantitatively expressed by FWHM / sub-scanning pitch (overlap coefficient). In the invention, the overlap coefficient is preferably 0.1 or greater.

There are no particular limitations on the scanning method of the light source of the light exposure apparatus used in the light exposure process, and a cylindrical outer surface scanning method, a cylindrical inner surface scanning method, a plane scanning method, and the like can be used. The channel of the light source may be a single channel or a multi-channel. In the case of the cylindrical outer surface mode, a multi-channel is preferably used.

In the invention, a development process may be carried out immediately after light exposure. Alternatively, heating process (so-called preheating) may be carried out between the light exposure process and the development process. Regarding the conditions for this heating process, it is preferable to carry out a heating process at a temperature in the range of from 60°C to 150°C for a processing time in the range of from 5 seconds to 5 minutes.

In the invention, it is preferable to use a thermal polymerization photosensitive composition and to carry out development process immediately after light exposure without performing preheating.

Development is carried out by supplying a light-exposed planographic printing plate to the automatic developing machine 10 of Fig. 1, and performing development using the negative developer liquid described above.

Pre-washing with water for removing the protective layer may be carried out before the development process. For the pre-washing with water, for example, tap water is used.

The thermal polymerization photosensitive planographic printing plate is developed using the developer liquid according to the invention described above after the thermal polymerization photosensitive planographic printing plate is light-exposed (or after subjected to the light exposure process and the heating processes); the printing plate may further be treated with water for washing that includes a chelating agent capable of forming a water-soluble chelate compound with an aluminum ion.

The photosensitive planographic printing plate that has been subjected to plate-making treatment in the manner described above may be subjected to post-treatment with a rinsing liquid that includes a surfactant or the like, or with an desensitizing liquid that includes gum arabic, a starch derivative, or the like, as disclosed in JP-A Nos. S54-8002, S55-115045, and S59-58431. For the post-treatment of the photosensitive planographic printing plate, these treatments may be employed in various combinations.

In the plate-making of the photosensitive planographic printing plate, it is effective to subject the image after development to entire-surface post-heating or entire-surface exposure to light, for the purpose of increasing the image strength and printing durability.

Very strong conditions may be employed for the heating after development. The heating after development is usually carried out at a heating temperature in the range of from 200°C to 500°C. When the heating temperature of the heating after development is 200°C or higher, a sufficient image strengthening effect can be more effectively obtained. When the heating temperature is 500°C or lower, problems such as deterioration of the support and thermal decomposition of the image areas can be more effectively prevented.

The planographic printing plate obtained by the above treatment is set in an offset printing machine and used in the printing of a large number of sheets.

At the time of printing, conventionally known plate cleaners for PS plates may be used as plate cleaners used for removal of contaminants on the plate, and examples thereof include CL-1, CL-2, CP, CN-4, CN, CG-1, PC-1, SR and IC (all trade names, manufactured by FUJIFILM Corporation).

### [Positive Planographic Printing Plate]

In the method of recycling plate-making process waste liquid according to the invention, a positive planographic printing plate can also be used besides the negative planographic printing plate described above. A positive planographic printing plate includes an image recording layer provided on a support, the image recording layer including an alkali-soluble resin and an infrared absorbing dye, and, optionally, a dissolution inhibitor or the like.

The configuration of the image recording layer is described below.

### (Infrared Absorbing Dye)

In the invention, the infrared absorbing dye used in the image recording layer is not particularly limited as long as it is a dye that absorbs infrared light to generate heat, and various dyes known as infrared absorbing dyes may be used.

Commercially available infrared absorbing dyes and known infrared absorbing dyes disclosed in literature (for example, "*Senryo-Binran*" (Handbook of Dyes) edited by *Yu-ki Go-sei Kagaku Kyokai* (the Association of Organic Synthetic Chemistry) and published in 1970) may be used. Specific examples thereof include azo dyes, metal complex salt azo dyes, pyrazolone azo dyes, quinoneimine dyes, methine dyes, and cyanine dyes. In the invention, dyes capable of absorbing infrared light or near-infrared light, among these dyes, are particularly preferable since they are compatible with use with lasers that emit infrared light or near-infrared light.

Any substance that absorbs light energy irradiation rays used for recording and generates heat can be used, without any particular limitations on absorption wavelength region, as an infrared absorbing dye usable in the invention. From the viewpoint of compatibility with easily-available high power output lasers, infrared absorbing dyes or pigments having an absorption maximum in the wavelength region of from 800 nm to 1200 nm are preferable.

Commercially available dyes and known dyes such as those disclosed in the literature "*Senryo*-*Binran*" (Handbook of Dyes) edited by *Yu-ki Go-sei Kagaku Kyokai* (the Association of Organic Synthetic Chemistry) and published in 1970 may be used as dyes. Specific examples include dyes disclosed in paragraphs [0050] and [0051] of JP-A No. H10-39509.

Among these dyes, examples of particularly preferable dyes include cyanine dyes, squarylium dyes, pyrylium dyes, and organic metal complexes (for example, dithiolate-based complexes). From the viewpoint of capability of forming an interaction with an alkali-soluble resin, cyanine dyes represented by Formula (I) of JP-A No. 2001-305722 are preferable.

The content of infrared absorbing dye in the image recording layer may be adjusted to be in the range of from 0.01% by mass to 50% by mass, preferably in the range of from 0.1 % by mass to 50% by mass, and particularly preferably in the range of from 0.1% by mass to 30% by mass, with respect to the mass of the image recording layer, from the viewpoints of sensitivity and the uniformity of the image recording layer.

### (Alkali-soluble Resin)

The alkali-soluble resin used in the image recording layer is a resin that is insoluble in water but soluble in alkaline water (hereinafter also referred to as an "alkali-soluble high-molecular-weight compound"), and the scope thereof includes homopolymers or copolymers that include an acidic group in the main chain and/or a side chain of the high-molecular-weight compound, or a mixture thereof. Therefore, the image recording layer of the planographic printing plate has properties such that the image recording layer dissolves upon contact with an alkaline developer liquid.

The alkali-soluble high-molecular-weight compound used in the image recording layer is not particularly limited as long as it is a conventionally known alkali-soluble high-molecular-weight compound. The alkali-soluble high-molecular-weight compound used in the image recording layer is preferably a high-molecular-weight compound having any one functional group selected from (1) a phenolic hydroxyl group, (2) a sulfonamido group, or (3) active imido group in a molecule thereof. Among them, a high-molecular-weight compound having (1) a phenolic hydroxyl group in a molecule thereof is preferable.

More specifically, high-molecular-weight compounds disclosed in paragraphs [0023] to [0042] of JP-A No. 2001-305722 are preferable.

Examples of the high-molecular-weight compound having (1) a phenolic hydroxyl group include novolac resins such as a phenol formaldehyde resin, an m-cresol formaldehyde resin, a p-cresol formaldehyde resin, an m-/p-mixed cresol formaldehyde resin, and a phenol/cresol (which may be any of m-, p-, or m-/p- mixture) mixed formaldehyde resin, and a pyrogallol acetone resin. Another preferable example of the high-molecular-weight compound having a phenolic hydroxyl group is a polymer compound having a phenolic hydroxyl group in a side chain. Examples of the high-molecular-weight compound having a phenolic hydroxyl group in a side chain include a high-molecular-weight compound obtained by homopolymerizing a polymerizable monomer that is a low-molecular-weight compound having one or more phenolic hydroxyl groups and one or more polymerizable unsaturated bonds, and a high-molecular-weight compound obtained by copolymerizing this monomer and at least one other polymerizable monomer.

Examples of the alkali-soluble high-molecular-weight compound having (2) a sulfonamido group include a high-molecular-weight compound obtained by homopolymerizing a polymerizable monomer having a sulfonamido group, and a high-molecular-weight compound obtained by copolymerizing this monomer and at least one other polymerizable monomer. Examples of the polymerizable monomer having a sulfonamido group include a polymerizable monomer that is a low-molecular-weight compound having, in one molecule thereof, one or more sulfonamido groups -NH-SO₂- in which at least one hydrogen atom is bonded to the nitrogen atom, and one or more polymerizable unsaturated bonds. Among others, low-molecular-weight compounds having an acryloyl group, an allyl group, or a vinyloxy group, and a substituted or monosubstituted aminosulfonyl group or a substituted sulfonylimino group, are preferable.

The alkali-soluble high-molecular-weight compound having (3) an active imido group preferably includes an active imido group in a molecule thereof, and examples of this high-molecular-weight compound include a high-molecular-weight compound obtained by homopolymerizing a polymerizable monomer that is a low-molecular-weight compound having one or more active imido groups and one or more polymerizable unsaturated bonds in one molecule thereof, and a high-molecular-weight compound obtained by copolymerizing this monomer and at least one other polymerizable monomer.

When the alkali-soluble high-molecular-weight compound is a copolymer of a polymerizable monomer having a phenolic hydroxyl group, a polymerizable monomer having a sulfonamido group, or a polymerizable monomer having an active imido group, and at least one other polymerizable monomer, the content of alkali-solubility-imparting monomer in the alkali-soluble high-molecular-weight compound is preferably 10 mol% or more, and more preferably 20 mol% or more, so that sufficient alkali-solubility is obtained and the effect in terms of enhancing development latitude is sufficiently achieved.

In the invention, when the alkali-soluble high-molecular-weight compound is a homopolymer or copolymer of a polymerizable monomer having a phenolic hydroxyl group, a polymerizable monomer having a sulfonamido group, or a polymerizable monomer having an active imido group, the alkali-soluble high-molecular-weight compound preferably has a weight average molecular weight of 2,000 or greater and a number average molecular weight of 500 or greater. The alkali-soluble high-molecular-weight compound more preferably has a weight average molecular weight of from 5,000 to 300,000, a number average molecular weight of from 800 to 250,000, and a dispersity (the ratio of weight average molecular weight to number average molecular weight) of from 1.1 to 10.

In the invention, when the alkali-soluble high-molecular-weight compound is a resin such as a phenol formaldehyde resin or a cresol-aldehyde resin, the alkali-soluble high-molecular-weight compound preferably has a weight average molecular weight of from 500 to 20,000, and a number average molecular weight of from 200 to 10,000.

These alkali-soluble high-molecular-weight compounds may be used singly, or in combination of two or more thereof. The image recording layer may include the alkali-soluble high-molecular-weight compound in an amount of 30% by mass to 99% by mass, preferably 40% by mass to 95% by mass, and particularly preferably 50% by mass to 90% by mass, with respect to the total solid content of the image forming layer. The range of content described above is appropriate in consideration of both of the durability of the image forming layer and the sensitivity of the image forming layer.

The image recording layer preferably includes a dissolution inhibitor from the viewpoint of sensitivity. Examples of the dissolution inhibitor are not particularly limited, and include quaternary ammonium salts and polyethylene glycol compounds.

When a means for improving the inhibition (inhibition of dissolution) is adopted, a decrease in sensitivity occurs. In this case, it is effective to incorporate a lactone compound into the image recording layer. It is presumed that when a developer liquid has penetrated into light-exposed areas, the developer liquid reacts with this lactone compound to newly generate a carboxylic acid compound, which contributes to dissolution of the light-exposed areas and improves sensitivity.

It is preferable to further use, in the image recording layer, a material which is thermally decomposable and of which the undecomposed form thereof substantially decreases the solubility of an alkaline-water soluble high-molecular-weight compound, from the viewpoint of increasing the capacity to inhibit dissolution of image areas in the developer liquid; examples of the material include an onium salt, an o-quinone diazide compound, an aromatic sulfone compound, and an aromatic sulfonic acid ester compound,. Examples of the onium salt include a diazonium salt, an ammonium salt, a phosphonium salt, an iodonium salt, a sulfonium salt, a selenonium salt, and an arsonium salt.

Regarding other additives, the image recording layer preferably includes, for example, compounds disclosed in paragraphs [0024] to [0027] of JP-A No. H07-92660, such as a sensitivity regulating agent, a print-out agent, or a dye, or a surfactant for improving coatability such as those disclosed in paragraph [0031] of JP-A No. H07-92660. Examples of other preferable surfactants include compounds disclosed in paragraphs [0053] to [0059] of JP-A No. 2001-305722.

### [Coating Amount]

The coating amount (solid content) of the image recording layer may vary with the use. From the viewpoints of film properties and printing durability, a coating amount of from 0.3 g/m² to 3.0 g/m² may be employed. The coating amount is preferably from 0.5 g/m² to 2.5 g/m², and more preferably from 0.8 g/m² to 1.6 g/m².

The image recording layer in the photosensitive planographic printing plate may have a single layer structure or a multilayer structure formed by plural recording layers disposed one on another. Examples of the image recording layer having a multilayer structure include a recording layer disclosed in JP-A No. H11-218914.

The image recording layer having a multilayer structure is described below. The image recording layer having a multilayer structure may have a multilayer configuration having at least two or more layers. Hereinafter, a case in which two layers - an upper layer and a lower layer - are provided is described for the purpose of convenience.

Each of the alkali-soluble resin that constitutes the upper layer and the alkali-soluble resin that constitutes the lower layer may respectively be selected from the alkali-soluble resins described above. It is preferable that the alkali-soluble resin that constitutes the upper layer have lower solubility in alkali than that of the alkali-soluble resin that constitutes the lower layer.

An infrared absorbing dye may be included in either one of the layers, or included in both layers. Infrared absorbing dyes included in the respective layers may differ layer by layer, and each layer may include plural compounds as infrared absorbing dyes. Regardless of which layer includes an infrared absorbing dye, the content of infrared absorbing dye in the layer containing an infrared absorbing dye may be adjusted to be from 0.01% by mass to 50% by mass, preferably 0.1 % by mass to 50% by mass, and particularly preferably 0.1 % by mass to 30% by mass, with respect to the total solid content of the layer containing an infrared absorbing dye, as described above. When plural layers include an infrared dye or infrared dyes, the total content in the plural layers is preferably adjusted to be in the range described above.

It is preferable to provide an undercoat layer between a thermal positive image recording layer and a support. Examples of components contained in the undercoat layer include various organic compounds disclosed in paragraph [0068] of JP-A No. 2001-305722.

### [Support]

An example of a hydrophilic support for use in the photosensitive planographic printing plate is a plate-shaped material that has required strength and durability and that is dimensionally stable. Examples thereof include: paper, paper laminated with plastic (for example, polyethylene, polypropylene, or polystyrene), metal plates (for example, aluminum, zinc, or copper), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, or polyvinyl acetal), and paper or a plastic films on which a metal, such as those described above, is laminated or deposited. Among them, polyester films or aluminum plates are preferable, and, among them, aluminum plates, having favorable dimensional stability and being relatively inexpensive, are particularly preferable.

The thickness of the aluminum plate used as the support may be from about 0.1 mm to about 0.6 mm, preferably from 0.15 mm to 0.4 mm, and particularly preferably from 0.2 mm to 0.3 mm.

An aluminum plate that has been subjected to any of various surface treatments may be used as the support. Surface treatment is carried out for the purpose of increasing surface hydrophilicity or increasing adhesiveness to the image recording layer, and examples thereof include surface roughening treatment, for example, mechanical surface roughening, electrochemical surface roughening, and chemical surface roughening treatments. In regard to these, the surface roughening treatment described in the above section for the negative planographic printing plate may be applied.

The aluminum plate that has been surface-roughened in this manner is subjected to alkali etching and neutralization, if necessary, and thereafter is optionally subjected to anodization treatment in order to increase moisture retention properties and abrasion resistance of the surface.

The aluminum plate is further subjected to hydrophilicity-imparting treatment, if necessary. For the hydrophilicity-imparting treatment, an alkali metal silicate (for example, a sodium silicate aqueous solution) method such as those disclosed in US Patent Nos. 2,714,066, 3,181,461, 3,280,734, and 3,902,734, a method including treatment with polyvinylphosphonic acid such as those disclosed in US Patent Nos. 3,276,868, 4,153,461, and 4,689,272, and the like may be used.

The photosensitive planographic printing plate used in the invention has a configuration in which at least the image recording layer described above is provided on a support; an undercoat layer may be provided between the support and the image recording layer, in accordance with the necessity.

Various organic compounds are used as components for the undercoat layer, and examples thereof include: carboxymethyl cellulose, dextrin, and gum Arabic; phosphonic acids having an amino groups, such as 2-aminoethylphosphonic acid; organic phosphonic acids, such as phenylphosphonic acid, naphthylphosphonic acid and alkylphosphonic acid, each of which may be substituted; organic phosphinic acids, such as phenylphosphinic acid and alkylphosphinic acid, each of which may be substituted; amino acids such as glycine and β-alanine; and hydrochlorides of amines having a hydroxyl group, such as hydrochloride of triethanolamine. These may be used in mixture of two or more thereof.

A coating amount of the undercoat layer of from about 2 mg/m² to about 200 mg/m² is appropriate, and the coating amount of the undercoat layer is preferably from 5 mg/m² to 100 mg/m², from the viewpoint of printing durability.

The photosensitive planographic printing plate produced as described above is imagewise exposed to light, and thereafter subjected to development using the alkali developer liquid described in detail above.

Development is carried out by supplying the light-exposed photosensitive planographic printing plate to the automatic developing machine 10 of Fig. 1.

Examples of a light source of an actinic light used for imagewise light exposure include a mercury lamp, a metal halide lamp, a xenon lamp, a chemical lamp, and a carbon arc lamp. Examples of the radiation include an electron beam, X-radiation, an ion beam, and far-infrared radiation. Further, g-line, i-line, Deep-UV light, and high density energy beam (laser beam) are also usable. Examples of lasers include a helium neon laser, an argon laser, a krypton laser, a helium cadmium laser, and a KrF excimer laser. In the invention, a light source having an emission wavelength in the range of from near-infrared to infrared region is preferable, and a solid laser and a semiconductor laser are particularly preferable.

### EXAMPLES

The invention is described below with reference to examples. However, the invention is not limited by the examples. In addition, "part(s)" and "%" are based on mass.

First, experiments were carried out using negative printing plates.

### [Example 1]

Continuous processing equivalent to processing of 5000 printing plates (500 mm x 400 mm) was carried out using a system of Fig. 1, and using: a newspaper CTP printing plate LH-NN2 (trade name), which is a negative photosensitive planographic printing plate manufactured by FUJIFILM Corporation; a developer liquid LP-DS for negative photosensitive planographic printing plate (trade name; this developer liquid includes 25% of Exemplary Compound Y-1 as a surfactant and 1% of potassium hydroxide, but includes neither of organic solvent nor silicate compound) manufactured by FUJIFILM Corporation; and a development replenisher liquid prepared by adding an organic solvent, diethanolamine (boiling point: 268°C), to LP-DRN (trade name; this product includes 10% of Exemplary Compound Y-1 as a surfactant and 5% of potassium hydroxide, but includes neither of organic solvent nor silicate compound) manufactured by FUJIFILM Corporation so as to provide a concentration of the organic solvent of 5% after addition. An automatic developing machine INTER PLATER (trade name) manufactured by G & J Company was used as the automatic developing machine in the system of Fig. 1.

The development conditions were as follows:
the developer liquid LP-DS was used after 5-fold (mass basis) dilution with water;
the development temperature was 25°C;
the pH was 11.95; and
the development time was 24 seconds.

The conditions for concentrating development waste liquid were as follows:
the concentration temperature was 30°C; and
the pressure was 30 mmHg.

The cooling conditions were such that the cooling temperature was 5°C. The developer liquid LP-DS after dilution included from 4% to 5% of Exemplary Compound Y-1 as a surfactant, and the content ratio of the organic solvent was 0.5% or less. The degree of concentration of the plate-making process waste liquid was 1/3. The regenerated water obtained was used as diluent water for the development replenisher liquid, such that the amount of the regenerated water used as diluent water was two times (by mass) the amount of the development replenisher liquid. The replenishment amount as a total of the development replenisher liquid and the regenerated water was adjusted to 90 ml per square meter (m²) area of the photosensitive planographic printing plate to be developed.

There was no accumulation of deposits in the development bath and the washing water bath of the automatic developing machine after the continuous processing, and contamination was hardly observed.

### [Example 2]

Continuous processing equivalent to processing of 5000 printing plates (500 mm x 400 mm) was carried out in the same manner as in Example 1, except that, instead of the development replenisher liquid used in Example 1, a development replenisher liquid prepared by adding a solvent, diethanolamine (boiling point: 268°C), to LP-DRN (trade name) manufactured by FUJIFILM Corporation so as to provide a concentration of the solvent of 10% after addition was used as the development replenisher liquid. In this process, the degree of concentration of the plate-making process waste liquid was adjusted to 1/3, and the regenerated water obtained was used as diluent water for the development replenisher liquid, such that the amount of the regenerated water used as diluent water was two times (by mass) the amount of the development replenisher liquid.

There was no accumulation of deposits in the development bath and the washing water bath of the automatic developing machine after the continuous processing, and contamination was hardly observed.

### [Comparative Example 1]

Continuous processing equivalent to processing of 5000 printing plates (500 mm x 400 mm) was carried out in the same manner as in Example 1, except that LP-DRN (trade name) manufactured by FUJIFILM Corporation was used, as it was, as the development replenisher liquid, without addition of a solvent. In this process, the degree of concentration of the plate-making process waste liquid was adjusted to 1/3.

A large amount of deposits were recognized in the development bath and the washing water bath of the automatic developing machine after the continuous processing, and contamination was observed.

### [Comparative Example 2]

Continuous processing equivalent to processing of 5000 printing plates (500 mm × 400 mm) was carried out in the same manner as in Example 1, except that a development replenisher liquid prepared by adding a solvent, diethanolamine (boiling point: 268°C), to LP-DRN (trade name) manufactured by FUJIFILM Corporation so as to provide a concentration of the solvent of 2% after addition was used as the development replenisher liquid. In this process, the degree of concentration of the plate-making process waste liquid was adjusted to 1/3, and the regenerated water was used as diluent water for the development replenisher liquid, and rinsing water.

Deposits were observed in the development bath and the washing water bath of the automatic developing machine after the continuous processing, and contamination was observed, similar to Comparative Example 1.

### [Comparative Example 3]

Continuous processing equivalent to processing of 5000 printing plates (500 mm × 400 mm) was carried out in the same manner as in Example 1, except that a development replenisher liquid prepared by adding a solvent, diethanolamine (boiling point: 268°C), to LP-DRN (trade name) manufactured by FUJIFILM Corporation so as to provide a concentration of the solvent of 40% after addition was used as the development replenisher liquid. In this process, the degree of concentration of the plate-making process waste liquid was adjusted to 1/1.8, and the degree of concentration did not reach 1/2.5. The regenerated water was used as diluent water for the development replenisher liquid, and rinsing water.

Although the amount of deposits in the development bath and the washing water bath of the automatic developing machine after the continuous processing was small, the film strength of images was deteriorated at the time of development, and the printing plate obtained had poor printing durability.

### [Comparative Example 4]

An experiment was carried out in the same manner as in Comparative Example 3, except that the degree of concentration was changed to 1/7.

With a degree of concentration of 1/7, aggregates formed from concentrated photosensitive material components remained and adhered, and the aggregates could not be removed from the pot.

### [Comparative Example 5]

Continuous processing equivalent to processing of 5000 printing plates (500 mm × 400 mm) was carried out in the same manner as in Example 1, except that a development replenisher liquid prepared by adding a solvent, ethanol, to LP-DRN (trade name) manufactured by FUJIFILM Corporation so as to provide a concentration of the solvent of 5% after addition was used as the development replenisher liquid. In this process, the degree of concentration of the plate-making process waste liquid was adjusted to 1/3.

Since the regenerated water obtained contained ethanol, the regenerated water emitted an alcohol odor, and was unusable.

### [Example 3]

Continuous processing equivalent to processing of 5000 printing plates (1100 mm × 400 mm) was carried out using a system of Fig. 1, and using: a newspaper CTP printing plate HN-V (trade name), which is a negative photosensitive planographic printing plate manufactured by FUJIFILM Corporation; a developer liquid HN-D for negative photosensitive planographic printing plate (trade name; this developer includes 15% of Exemplary Compound (1) as a surfactant and 1% of potassium hydroxide, but includes neither of organic solvent nor silicate compound) manufactured by FUJIFILM Corporation; and a development replenisher liquid prepared by adding an organic solvent, diethanolamine (boiling point: 268°C), to HN-DR (trade name; this product includes 8% of Exemplary Compound (1) as a surfactant and 5% of potassium hydroxide, but includes neither of organic solvent nor silicate compound) manufactured by FUJIFILM Corporation so as to provide a concentration of the organic solvent of 5% after addition. An automatic developing machine LP-1310 NEWSII (trade name) manufactured by FUJIFILM Corporation was used as the automatic developing machine in the system of Fig. 1.

The development conditions were as follows:
the developer liquid HN-D was used after 5-fold (mass basis) dilution with water;
the development temperature was 30°C;
the pH was 12.0; and
the development time was 12 seconds.

The conditions for concentrating development waste liquid were as follows:
the concentration temperature was 30°C; and
the pressure was 30 mmHg.

The cooling conditions were such that the cooling temperature was 5°C. The developer liquid HN-D after dilution included 4% of Exemplary Compound (1) within the scope of Formula (I-B) as a surfactant, and the content ratio of the organic solvent was 0.5% or less. The degree of concentration of the plate-making process waste liquid was 1 /3. The regenerated water obtained was used as diluent water for the development replenisher liquid, such that the amount of the regenerated water used as diluent water was 1.4 times (by mass) the amount of the development replenisher liquid. The replenishment amount as a total of the development replenisher liquid and the regenerated water was adjusted to 60 ml per square meter (m²) area of the photosensitive planographic printing plate to be developed.

There was no accumulation of deposits in the development bath and the washing water bath of the automatic developing machine after the continuous processing, and contamination was hardly observed.

### [Example 4]

Continuous processing equivalent to processing of 5000 printing plates (1100 mm × 400 mm) was carried out in the same manner as in Example 3, except that a development replenisher liquid prepared by adding a solvent, diethanolamine (boiling point: 268°C), to HN-DR (trade name) manufactured by FUJIFILM Corporation such thaat the concentration of the solvent after addition was 10% was used as the development replenisher liquid. In this process, the degree of concentration of the plate-making process waste liquid was adjusted to 1/3, and the regenerated water obtained was used as diluent water for the development replenisher liquid, such that the amount of the regenerated water used as diluent water was 1.4 times (by mass) the amount of the development replenisher liquid.

There was no accumulation of deposits in the development bath and the washing water bath of the automatic developing machine after the continuous processing, and contamination was hardly observed.

### [Comparative Example 6]

Continuous processing equivalent to processing of 5000 printing plates (1100 mm × 400 mm) was carried out in the same manner as in Example 1, except that HN-DR (trade name) manufactured by FUJIFILM Corporation was used, as it was, as the development replenisher liquid, without addition of an organic solvent. In this process, the degree of concentration of the plate-making process waste liquid was adjusted to 1/3.

A large amount of deposits were recognized in the development bath and the washing water bath of the automatic developing machine after the continuous processing, and contamination was observed.

Next, experiments were carried out using positive printing plates.

### [Comparative Example 7]

Printing plates equivalent to 5000 *kikuzen* size (636 mm × 939 mm) printing plates were processed over one month period using the system of Fig. 1, and using: a thermal positive CTP plate XP-T (trade name), manufactured by FUJIFILM Corporation; a positive developer liquid XP-D (trade name; this developer liquid includes 30% of D-sorbitol potassium salt and 3% of potassium citrate, but includes neither of organic solvent nor silicate compound) manufactured by FUJIFILM Corporation; and XP-DR (trade name; this product includes 40% of D-sorbitol potassium salt and 10% of potassium hydroxide, but includes neither of organic solvent nor silicate compound), manufactured by FUJIFILM Corporation as a development replenisher liquid. The developer liquid XP-D was 9-fold (mass basis) diluted by addition of fresh water, and the development replenisher liquid XP-DR was 7.5-fold (mass basis) diluted by addition of fresh water that included regenerated water. In this process, the degree of concentration of the plate-making process waste liquid was adjusted to 1/5. An automatic developing machine LP-1310HII (trade name) manufactured by FUJIFILM Corporation was used under standard settings as the automatic developing machine in the system of Fig. 1. The development temperature in this process was 30°C, and the development time was 12 seconds. The replenishment amount in total of the development replenisher liquid and regenerated water was 100 ml per square meter (m²) area of the photosensitive planographic printing plate to be developed.

Since the development replenisher liquid used in Comparative Example 7 did not include an organic solvent, the solubility of image recording layer components in the plate-making process waste liquid was poor. Aggregates formed from concentrated photosensitive material components remained in the development bath, the washing water bath and the rollers of the automatic developing machine after the processing over the one month period, and scrub washing of the automatic developing machine tanks and rollers was necessary.

### [Example 5]

Printing plates equivalent to 5000 *kikuzen* size (636 mm × 939 mm) printing plates were processed over one month period in the same manner as in Comparative Example 7, except that a development replenisher liquid obtained by adding a solvent, benzyl alcohol (boiling point: 205°C), to XP-DR (trade name) manufactured by FUJIFILM Corporation so as to provide a concentration of the solvent of 5% after addition was used as the development replenisher liquid. In this process, the degree of concentration of the plate-making process waste liquid was adjusted to 1/5; the regenerated water obtained was used as diluent water for the development replenisher liquid, and the amount of the regenerated water used as diluent water was 6.5 times (by mass) the amount of the development replenisher liquid.

Residual aggregates on the development bath, the washing water bath and the rollers of the automatic developing machine after the processing over the one month period was reduced to half or less compared to that in Comparative Example 7, and washing became easier.

### [Example 6]

Printing plates equivalent to 5000 *kikuzen* size (636 mm × 939 mm) printing plates were processed for one month period in the same manner as in Comparative Example 7, except that a development replenisher liquid obtained by adding a solvent, benzyl alcohol (boiling point: 205°C), to XP-DR (trade name) manufactured by FUJIFILM Corporation so as to provide a concentration of the solvent of 10% after addition was used as the development replenisher liquid. In this process, the degree of concentration of the plate-making process waste liquid was adjusted to 1/5; the regenerated water obtained was used as diluent water for the development replenisher liquid, and the amount of the regenerated water used as diluent water was 6.5 times (by mass) the amount of the development replenisher liquid.

Residual aggregates on the development bath, washing water bath and rollers of the automatic developing machine after the processing for the one month period was reduced to half or less compared to that in Comparative Example 7, and washing became easier.

### [Comparative Example 8]

Printing plates equivalent to 5000 *kikuzen* size (636 mm × 939 mm) printing plates were processed for one month period in the same manner as in Comparative Example 7, except that a development replenisher liquid obtained by adding a solvent, benzyl alcohol (boiling point: 205°C), to XP-DR (trade name) manufactured by FUJIFILM Corporation so as to provide a concentration of the solvent of 1% after addition was used as the development replenisher liquid. In this process, the degree of concentration of the plate-making process waste liquid was adjusted to 1/5.

Residual aggregates on the development bath, washing water bath and rollers of the automatic developing machine after the processing for the one month period was at the same level as that in Comparative Example 7, and washing properties were also the same as in Comparative Example 7.

### [Comparative Example 9]

Printing plates equivalent to 5000 *kikuzen* size (636 mm × 939 mm) printing plates were processed for one month period in the same manner as in Comparative Example 7, except that a development replenisher liquid obtained by adding a solvent, benzyl alcohol (boiling point: 205°C), to XP-DR (trade name) manufactured by FUJIFILM Corporation so as to provide a concentration of the solvent of 5% after addition was used as the development replenisher liquid. In this process, the degree of concentration of the plate-making process waste liquid was adjusted to 1/2.

Although the processing was carried out for the one month period, the amount of waste liquid was excessively large, indicating that the effect in terms of recycling regenerated water was small.

### [Comparative Example 10]

It was attempted to process printing plates equivalent to 5000 *kikuzen* size (636 mm × 939 mm) printing plates over one month period in the same manner as in Comparative Example 7, except that a development replenisher liquid obtained by adding a solvent, benzyl alcohol (boiling point: 205°C), to XP-DR (trade name) manufactured by FUJIFILM Corporation so as to provide a concentration of the solvent of 5% after addition was used as the development replenisher liquid, and that the degree of concentration of the plate-making process waste liquid was adjusted to 1/10. However, precipitation occurred in the concentration pot, and operation was stopped.

### [Comparative Example 11]

Printing plates equivalent to 5000 *kikuzen* size (636 mm × 939 mm) printing plates were processed over one month period in the same manner as in Example 5, except that a modified system was used instead of the system of Fig. 1, the modified system being modified from the system of Fig. 1 such that the system discharged the regenerated water discharged from the evaporation concentration apparatus as waste liquid rather than reutilizing the regenerated water. In this process, the degree of concentration of the plate-making process waste liquid was adjusted to 1/5.

The obtained regenerated water contained benzyl alcohol. Although the regenerated water could suitably be used as regenerated water for dilution of the development replenisher liquid in the system of Fig. 1, the regenerated water in the modified system could not be discharged, as it was, to drainage due to the BOD value of the regenerated water being 1000 mg/L, which is higher than the regulation value permitted for drain water.

## Claims

1. A method of recycling waste liquid from a plate-making process for a photosensitive planographic printing plate that is discharged by a plate-making process for a photosensitive planographic printing plate using a developer liquid for a photosensitive planographic printing plate in an automatic developing machine, the method comprising:
replenishing a development bath of the automatic developing machine with a development replenisher liquid without dilution or after dilution of the development replenisher liquid with an amount of water no more than 10 times an amount of the development replenisher liquid in terms of mass, the development replenisher liquid including an organic solvent having a boiling point in a range of from 100°C to 300°C, and a content ratio of organic solvent having a boiling point in a range of from 100°C to 300°C in the development replenisher liquid being in a range of from 5% by mass to 30% by mass;
concentrating plate-making process waste liquid, which has been generated during a plate-making process for a photosensitive planographic printing plate in the automatic developing machine, by evaporation using an evaporation concentration apparatus such that a ratio of an amount of the plate-making process waste liquid after the concentrating, to an amount of the plate-making process waste liquid before the concentrating, is in a range of from 1/2.5 to 1/5 in terms of volume, thereby separating the plate-making process waste liquid into water vapor and dissolved components;
recovering the separated water vapor from the evaporation concentration apparatus and condensing the water vapor in a cooling means to obtain regenerated water; and
using the obtained regenerated water as at least one of diluent water for the development replenisher liquid or rinsing water in the automatic developing machine.

2. The method of recycling plate-making process waste liquid according to claim 1, wherein the development replenisher liquid further includes a surfactant, a content ratio of surfactant in the development replenisher liquid being in a range of from 0.5% by mass to 10% by mass.

3. The method of recycling plate-making process waste liquid according to claim 2, wherein the surfactant includes at least one anionic surfactant selected from the group consisting of a compound represented by the following Formula (I-A) and a compound represented by the following Formula (I-B): 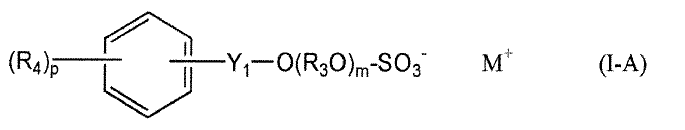 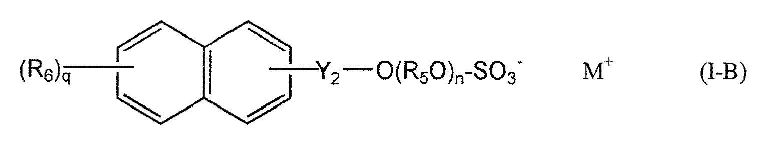 wherein, in Formula (I-A), R₃ represents a straight-chain or branched-chain alkylene group having from 1 to 5 carbon atoms; R₄ represents a straight-chain or branched-chain alkyl group having from 1 to 20 carbon atoms; p represents 0, 1 or 2; Y₁ represents a single bond or an alkylene group having from 1 to 10 carbon atoms; m represents an integer from 1 to 100; when m is 2 or greater, plural R₃'s are present, and the plural R₃'s may be the same as or different from each other; and M⁺ represents Na⁺, K⁺, Li⁺ or NH₄⁺; and
wherein, in Formula (I-B), R₅ represents a straight-chain or branched-chain alkylene group having from 1 to 5 carbon atoms; R₆ represents a straight-chain or branched-chain alkyl group having from 1 to 20 carbon atoms; q represents 0, 1 or 2; Y₂ represents a single bond or an alkylene group having from 1 to 10 carbon atoms; n represents an integer from 1 to 100; when n is 2 or greater, plural R₅'s are present, and the plural R₅'s may be the same as or different from each other; and M⁺ represents Na⁺, K⁺, Li⁺ or NH₄⁺.

4. The method of recycling plate-making process waste liquid according to claim 2, wherein the surfactant includes at least one nonionic surfactant selected from the group consisting of a compound represented by the following Formula (II-A) and a compound represented by the following Formula (II-B): 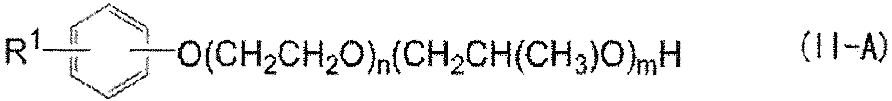 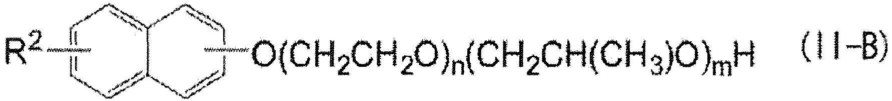 wherein, in Formula (II-A), R¹ represents a hydrogen atom or an alkyl group having from 1 to 100 carbon atoms; each of n and m independently represents an integer from 0 to 100; and n and m are not simultaneously 0; and
wherein, in Formula (II-B), R² represents a hydrogen atom or an alkyl group having from 1 to 100 carbon atoms; each of n and m independently represents an integer from 0 to 100; and n and m are not simultaneously 0.

5. The method of recycling plate-making process waste liquid according to any one of claim 1 to claim 4, wherein the evaporation concentration apparatus includes a heating means and a pressure reducing means for reducing pressure inside the evaporation concentration apparatus, and the evaporation concentration apparatus heats the plate-making process waste liquid while performing pressure reduction.

6. The method of recycling plate-making process waste liquid according to claim 5, wherein the heating means includes a heat pump, heats the plate-making process waste liquid to generate water vapor at a heat release part of the heat pump, and cools the water vapor at a heat absorbing part of the heat pump.

7. The method of recycling plate-making process waste liquid according to any one of claim 1 to claim 6, further comprising recovering concentrated matter from the plate-making process waste liquid, which has been concentrated by evaporation, into a recovery tank through application of a pressure using a pump.

8. The method of recycling plate-making process waste liquid according to any one of claim 1 to claim 7, wherein the ratio of the amount of the plate-making process waste liquid after the concentrating, to the amount of the plate-making process waste liquid before the concentrating, is in a range of from 1/3 to 1/5 in terms of volume.

9. The method of recycling plate-making process waste liquid according to any one of claim 1 to claim 8, wherein a content ratio of the organic solvent having a boiling point in a range of from 100°C to 300°C in the development replenisher liquid is in a range of from 5% by mass to 20% by mass.

10. The method of recycling plate-making process waste liquid according to any one of claim 1 to claim 9, wherein the organic solvent having a boiling point in a range of from 100°C to 300°C includes an organic solvent selected from the group consisting of 2-phenylethanol, 3-phenyl-1-propanol, 2-phenoxyethanol, benzyl alcohol, cyclohexanol, monoethanolamine, diethanolamine, cyclohexanone, ethyl lactate, propylene glycol, ethylene glycol, γ-butyrolactone, N-methylpyrrolidone, N-ethylpyrrolidone, propylene glycol monomethyl ether, ethylene glycol monomethyl ether, ethylene glycol monomethyl ether acetate, diethylene glycol dimethyl ether, and glycerin.

11. The method of recycling plate-making process waste liquid according to any one of claim 1 to claim 10, wherein the organic solvent having a boiling point in a range of from 100°C to 300°C includes an organic solvent selected from the group consisting of benzyl alcohol, diethanolamine, monoethanolamine, γ-butyrolactone, N-methylpyrrolidone, and N-ethylpyrrolidone.

12. The method of recycling plate-making process waste liquid according to any one of claim 1 to claim 11, further comprising performing one or more selected from (i) analyzing components of the regenerated water and neutralizing the regenerated water based on a result of the analysis, or (ii) supplying fresh water to the regenerated water.

13. The method of recycling plate-making process waste liquid according to any one of claim 1 to claim 12, wherein the photosensitive planographic printing plate is a negative planographic printing plate.

14. The method of recycling plate-making process waste liquid according to claim 13, wherein the developer liquid for a photosensitive planographic printing plate used for the negative planographic printing plate is an alkali developer liquid that includes a surfactant and a hydroxide of an alkali metal but does not include a silicate compound, and that has a pH in a range of from 10 to 12.5.

15. The method of recycling plate-making process waste liquid according to any one of claim 1 to claim 12, wherein the photosensitive planographic printing plate is a positive planographic printing plate.

16. The method of recycling plate-making process waste liquid according to claim 15, wherein the developer liquid for a photosensitive planographic printing plate used for the positive planographic printing plate is an alkali developer liquid that includes an organic compound having a buffering action and a base, and that does not include a silicate compound.

## Patentansprüche

1. Verfahren zum Recyceln einer Abfallflüssigkeit aus einem Plattenherstellungsprozess für eine fotoempfindliche Flachdruckplatte, die aus einem Plattenherstellungsprozess für eine fotoempfindliche Flachdruckplatte ausgestoßen wird, bei dem eine Entwicklerflüssigkeit für eine fotoempfindliche Flachdruckplatte in einer automatischen Entwicklungsmaschine verwendet wird, wobei das Verfahren umfasst:
Auffrischen eines Entwicklungsbads der automatischen Entwicklungsmaschine mit einer Entwicklungsauffrischflüssigkeit ohne Verdünnung oder nach Verdünnung der Entwicklungsauffrischflüssigkeit mit einer in Masse ausgedrückten Wassermenge, die nicht mehr als das 10-fache der Menge der Entwicklungsauffrischflüssigkeit beträgt, wobei die Entwicklungsauffrischflüssigkeit ein organisches Lösungsmittel mit einem Siedepunkt im Bereich von 100°C bis 300°C umfasst und der Mengenanteil des organischen Lösungsmittels mit einem Siedepunkt im Bereich von 100°C bis 300°C in der Entwicklungsauffrischflüssigkeit im Bereich von 5 Masse% bis 30 Masse% liegt;
Konzentrieren der Abfallflüssigkeit aus dem Plattenherstellungsprozess, die während eines Plattenherstellungsprozesses für eine fotoempfindliche Flachdruckplatte in der automatischen Entwicklungsmaschine generiert worden ist, durch Verdampfung unter Verwendung einer Verdampfungs-Konzentrationsvorrichtung, so dass das Mengenverhältnis der Abfallflüssigkeit aus dem Plattenherstellungsprozess nach dem Konzentrieren zur Menge der Abfallflüssigkeit aus dem Plattenherstellungsprozess vor dem Konzentrieren im Bereich von 1/2,5 bis 1/5 beträgt, ausgedrückt als Volumen, wodurch die Abfallflüssigkeit des Plattenherstellungsprozesses zu Wasserdampf und gelösten Komponenten getrennt wird;
Rückgewinnen des abgetrennten Wasserdampfs aus der Verdampfungs-Konzentrationsvorrichtung und Kondensieren des Wasserdampfs in einer Kühlvorrichtung, um regeneriertes Wasser zu erhalten; und
Verwenden des erhaltenen regenerierten Wassers als zumindest eines von Verdünnungswasser für die Entwicklungsauffrischflüssigkeit oder als Spülwasser in der automatischen Entwicklungsmaschine.

2. Verfahren zum Recyceln einer Abfallflüssigkeit aus einem Plattenherstellungsprozess gemäß Anspruch 1, worin die Entwicklungsauffrischflüssigkeit ferner ein Tensid umfasst, wobei der Mengenanteil des Tensids in der Entwicklungsauffrischflüssigkeit im Bereich von 0,5 Masse% bis 10 Masse% liegt.

3. Verfahren zum Recyceln einer Abfallflüssigkeit aus einem Plattenherstellungsprozess gemäß Anspruch 2, worin das Tensid mindestens ein anionisches Tensid umfasst, ausgewählt aus der Gruppe, bestehend aus einer durch die folgendes Formel (I-A) dargestellten Verbindung und einer durch die folgende Formel (I-B) dargestellten Verbindung: 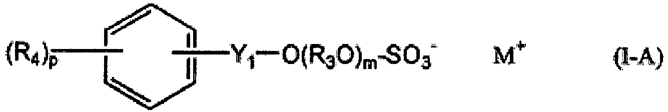 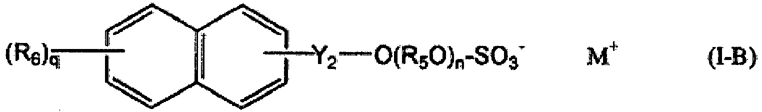 worin in der Formel (I-A) R₃ eine geradkettige oder verzweigte Alkylengruppe mit 1 bis 5 Kohlenstoffatomen darstellt; R₄ eine geradkettige oder verzweigte Alkylgruppe mit 1 bis 20 Kohlenstoffatomen darstellt; p 0, 1 oder 2 darstellt; Y₁ eine Einfachbindung oder eine Alkylengruppe mit 1 bis 10 Kohlenstoffatomen darstellt; m eine ganze Zahl von 1 bis 100 darstellt; wenn m 2 oder größer ist, die mehreren R₃ vorliegen und die mehreren R₃ gleich oder voneinander verschieden sein können; und M⁺ Na⁺, K⁺, Li⁺ oder NH₄⁺ darstellt; und
worin in Formel (I-B) R₅ eine geradkettige oder verzweigte Alkylengruppe mit 1 bis 5 Kohlenstoffatomen darstellt; R₆ eine geradkettige oder verzweigte Alkylgruppe mit 1 bis 20 Kohlenstoffatomen darstellt; 0, 1 oder 2 darstellt; Y₂ eine Einfachbindung oder eine Alkylengruppe mit 1 bis 10 Kohlenstoffatomen darstellt; n eine ganze Zahl von 1 bis 100 darstellt; wenn n 2 oder größer ist, die mehreren R₅ vorliegen und die mehreren R₅ gleich oder voneinander verschieden sein können; und M⁺ Na⁺, K⁺, Li⁺ oder NH₄⁺ darstellt.

4. Verfahren zum Recyceln einer Abfallflüssigkeit aus einem Plattenherstellungsprozess gemäß Anspruch 2, worin das Tensid mindestens ein nicht-ionisches Tensid umfasst, ausgewählt aus der Gruppe, bestehend aus einer durch die folgende Formel (II-A) dargestellten Verbindung und einer durch die folgende Formel (II-B) dargestellten Verbindung: 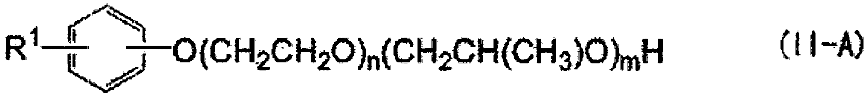 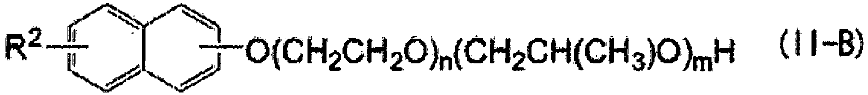 worin in Formel (II-A) R¹ ein Wasserstoffatom oder eine Alkylgruppe mit 1 bis 100 Kohlenstoffatomen darstellt; jedes von n und m unabhängig eine ganze Zahl von 0 bis 100 darstellt; und n und m nicht gleichzeitig 0 sind; und
worin in der Formel (II-B) R² ein Wasserstoffatom oder eine Alkylgruppe mit 1 bis 100 Kohlenstoffatomen darstellt, jedes von n und m unabhängig eine ganze Zahl von 0 bis 100 darstellt; und n und m nicht gleichzeitig 0 sind.

5. Verfahren zum Recyceln einer Abfallflüssigkeit aus einem Plattenherstellungsprozess gemäß irgendeinem der Ansprüche 1 bis 4, worin die Verdampfungs-Konzentrationsvorrichtung ein Erwärmungsmittel und ein Mittel zum Reduzieren des Drucks zum Reduzieren des Drucks innerhalb der Verdampfungs-Konzentrationsvorrichtung umfasst, und worin die Verdampfungs-Konzentrationsvorrichtung die Abfallflüssigkeit aus dem Plattenherstellungsprozess erwärmt, während eine Druckreduzierung durchgeführt wird.

6. Verfahren zum Recyceln einer Abfallflüssigkeit aus einem Plattenherstellungsprozess gemäß Anspruch 5, worin das Erwärmungsmittel eine Wärmepumpe umfasst, die die Abfallflüssigkeit aus dem Plattenherstellungsprozess an dem Wärmefreisetzungsteil der Wärmepumpe erwärmt, um Wasserdampf zu generieren, und die den Wasserdampf an einem Wärme-absorbierenden Teil der Wärmepumpe kühlt.

7. Verfahren zum Recyceln einer Abfallflüssigkeit aus einem Plattenherstellungsprozess gemäß irgendeinem der Ansprüche 1 bis 6, ferner umfassend das Rückgewinnen einer konzentrierten Substanz aus der Abfallflüssigkeit aus dem Plattenherstellungsprozess, welche durch die Verdampfung konzentriert worden ist, zu einem Rückgewinnungstank durch die Anwendung eines Drucks unter Verwendung einer Pumpe.

8. Verfahren zum Recyceln einer Abfallflüssigkeit aus einem Plattenherstellungsprozess gemäß irgendeinem der Ansprüche 1 bis 7, worin das Verhältnis der Menge der Abfallflüssigkeit aus dem Plattenherstellungsprozess nach dem Konzentrieren zu der Menge der Abfallflüssigkeit aus dem Plattenherstellungsprozess vor dem Konzentrieren im Bereich von 1/3 bis 1/5 liegt, ausgedrückt als Volumen.

9. Verfahren zum Recyceln einer Abfallflüssigkeit aus einem Plattenherstellungsprozess gemäß irgendeinem der Ansprüche 1 bis 8, worin der Mengenanteil des organischen Lösungsmittels mit einem Siedepunkt im Bereich von 100°C bis 300°C in der Entwicklungsauffrischflüssigkeit im Bereich von 5 Masse% bis 20 Masse% liegt.

10. Verfahren zum Recyceln einer Abfallflüssigkeit aus einem Plattenherstellungsprozess gemäß irgendeinem der Ansprüche 1 bis 9, worin das organische Lösungsmittel mit einem Siedepunkt im Bereich von 100°C bis 300°C ein organisches Lösungsmittel umfasst, das ausgewählt aus der Gruppe, bestehend aus 2-Phenylethanol, 3-Phenyl-1-propanol, 2-Phenoxyethanol, Benzylalkohol, Cyclohexanol, Monoethanolamin, Diethanolamin, Cyclohexanon, Ethyllactat, Propylenglycol, Ethylenglycol, γ-Butyrolacton, N-Methylpyrrolidon, N-Ethylpyrrolidon, Propylenglycolmonomethylether, Ethylenglycolmonomethylether, Ethylenglycolmonomethyletheracetat, Diethylenglycoldimethylether und Glycerin.

11. Verfahren zum Recyceln einer Abfallflüssigkeit aus einem Plattenherstellungsprozess gemäß irgendeinem der Ansprüche 1 bis 10, worin das organische Lösungsmittel mit einem Siedepunkt im Bereich von 100°C bis 300°C ein organisches Lösungsmittel umfasst, das ausgewählt ist aus der Gruppe, bestehend aus Benzylalkohol, Diethanolamin, Monoethanolamin, γ-Butyrolacton, N-Methylpyrrolidon und N-Ethylpyrrolidon.

12. Verfahren zum Recyceln einer Abfallflüssigkeit aus einem Plattenherstellungsprozess gemäß irgendeinem der Ansprüche 1 bis 11, ferner umfassend das Durchführen von einem oder mehr, ausgewählt aus (i) Analysieren der Komponenten des regenerierten Wassers und Neutralisieren des regenerierten Wassers auf Grundlage des Ergebnisses der Analyse, oder (ii) Zuführen von Frischwasser zu dem regenerierten Wasser.

13. Verfahren zum Recyceln einer Abfallflüssigkeit aus einem Plattenherstellungsprozess gemäß irgendeinem der Ansprüche 1 bis 12, worin die fotoempfindliche Flachdruckplatte eine negative Flachdruckplatte ist.

14. Verfahren zum Recyceln einer Abfallflüssigkeit aus einem Plattenherstellungsprozess gemäß Anspruch 13, worin die Entwicklungsflüssigkeit für eine fotoempfindliche Flachdruckplatte, die für die negative Flachdruckplatte verwendet wird, eine Alkali-Entwicklerflüssigkeit ist, die ein Tensid und ein Hydroxid eines Alkalimetalls umfasst, jedoch keine Silikatverbindung enthält, und die einen pH-Wert im Bereich von 10 bis 12,5 aufweist.

15. Verfahren zum Recyceln einer Abfallflüssigkeit aus einem Plattenherstellungsprozess gemäß irgendeinem der Ansprüche 1 bis 12, worin die fotoempfindliche Flachdruckplatte eine positive Flachdruckplatte ist.

16. Verfahren zum Recyceln einer Abfallflüssigkeit aus einem Plattenherstellungsprozess gemäß Anspruch 15, worin die Entwicklerflüssigkeit für eine fotoempfindliche Flachdruckplatte, die für die positive Flachdruckplatte verwendet wird, eine Alkali-Entwicklerflüssigkeit ist, die eine organische Verbindung mit Pufferwirkung und eine Base enthält, und die keine Silikatverbindung enthält.

## Revendications

1. Procédé de recyclage de liquide résiduaire produit par un procédé de fabrication de plaques pour une plaque d'impression planographique photosensible, qui est rejeté par un procédé de fabrication de plaque pour une plaque d'impression planographique photosensible utilisant un révélateur liquide pour une plaque d'impression planographique photosensible dans une machine à développer automatique, le procédé comprenant :
le réapprovisionnement d'un bain de développement de la machine à développer automatique avec un liquide de réapprovisionnement de développement sans dilution ou après dilution du liquide de réapprovisionnement de développement avec une quantité d'eau non supérieure à 10 fois la quantité de liquide de réapprovisionnement de développement en termes de masse, le liquide de réapprovisionnement de développement comprenant un solvant organique ayant un point d'ébullition dans une plage de 100 °C à 300 °C et un rapport de teneurs de solvant organique ayant un point d'ébullition dans une plage de 100 °C à 300 °C au liquide de réapprovisionnement de développement dans une plage de 5 % en masse à 30 % en masse ;
la concentration du liquide résiduaire produit par le procédé de fabrication de plaques, qui a été produit pendant le procédé de fabrication de plaques pour une plaque d'impression planographique photosensible dans la machine à développer automatique, par évaporation à l'aide d'un appareil de concentration par évaporation de sorte que le rapport de la quantité du liquide résiduaire produit par le procédé de fabrication de plaques après la concentration à la quantité de liquide résiduaire produit par le procédé de fabrication de plaques avant la concentration soit dans une plage de 1/2, 5 à 1/5 en termes de volume, en séparant ainsi le liquide résiduaire produit par le procédé de fabrication de plaques en vapeur d'eau et composants dissous ;
la récupération de la vapeur d'eau séparée provenant de l'appareil de concentration par évaporation et la condensation de la vapeur d'eau dans un moyen de refroidissement pour obtenir de l'eau régénérée ; et
l'utilisation de l'eau régénérée obtenue comme au moins eau de dilution pour le liquide de réapprovisionnement de développement ou eau de rinçage dans la machine à développer automatique.

2. Procédé de recyclage de liquide résiduaire produit par un procédé de fabrication de plaques selon la revendication 1, dans lequel le liquide de réapprovisionnement de développement comprend en outre un tensioactif, le rapport de la teneur en tensioactif au liquide de réapprovisionnement de développement étant dans une plage de 0,5 % en masse à 10 % en masse.

3. Procédé de recyclage de liquide résiduaire produit par un procédé de fabrication de plaques selon la revendication 2, dans lequel le tensioactif comprend au moins un tensioactif anionique choisi dans le groupe constitué d'un composé représenté par la formule (I-A) suivante et d'un composé représenté par la formule (I-B) suivante : 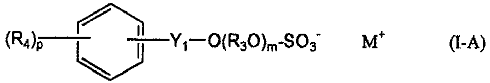 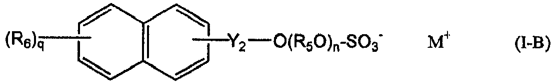 dans lequel , dans la formule (I-A), R₃ représente un groupe alkylène à chaîne droite ou à chaîne ramifiée comportant de 1 à 5 atomes de carbone ; R₄ représente un groupe alkyle à chaîne droite ou à chaîne ramifiée comportant de 1 à 20 atomes de carbone ; p représente 0, 1 ou 2 ; Y₁ représente une liaison simple ou un groupe alkylène comportant de 1 à 10 atomes de carbone ; m représente un nombre entier de 1 à 100 ; lorsque m est supérieur ou égal à 2, de multiples R₃ sont présents et les multiples R₃ peuvent être identiques ou différents les uns des autres ; et M⁺ représente Na⁺, K⁺, Li⁺ ou NH₄⁺ ; et
dans laquelle, dans la formule (I-B), R₅ représente un groupe alkylène à chaîne droite ou à chaîne ramifiée comportant de 1 à 5 atomes de carbone ; R₆ représente un groupe alkyle à chaîne droite ou à chaîne ramifiée comportant de 1 à 20 atomes de carbone ; q représente 0, 1 ou 2 ; Y₂ représente une liaison simple ou un groupe alkylène comportant de 1 à 10 atomes de carbone ; n représente un nombre entier de 1 à 100 ; lorsque n est supérieur ou égal à 2, de multiples R₅ sont présents et les multiples R₅ peuvent être identiques ou différents les uns des autres ; et M⁺ représente Na⁺, K⁺, Li⁺ ou NH₄⁺.

4. Procédé de recyclage de liquide résiduaire produit par un procédé de fabrication de plaques selon la revendication 2, dans lequel le tensioactif comprend au moins un tensioactif non ionique choisi dans le groupe constitué d'un composé représenté par la formule (II-A) suivante et d'un composé représenté par la formule (II-B) suivante : 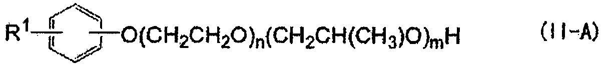 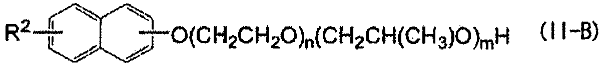 dans lequel , dans la formule (II-A), R¹ représente un atome d'hydrogène ou un groupe alkyle comportant de 1 à 100 atomes de carbone ; chacun de n et de m représente indépendamment un nombre entier de 0 à 100 ; et n et m ne sont pas simultanément 0 ; et
dans lequel , dans la formule (II-B), R² représente un atome d'hydrogène ou un groupe alkyle comportant de 1 à 100 atomes de carbone ; chacun de n et de m représente indépendamment un nombre entier de 0 à 100 ; et n et m ne sont pas simultanément 0.

5. Procédé de recyclage de liquide résiduaire produit par un procédé de fabrication de plaques selon l'une quelconque de la revendication 1 à la revendication 4, dans lequel l'appareil de concentration par évaporation comprend un moyen de chauffage et un moyen de réduction de pression pour réduire la pression à l'intérieur de l'appareil de concentration par évaporation, et l'appareil de concentration par évaporation chauffe le liquide résiduaire produit par le procédé de fabrication de plaques tout en réalisant une réduction de pression.

6. Procédé de recyclage de liquide résiduaire produit par un procédé de fabrication de plaques selon la revendication 5, dans lequel le moyen de chauffage comprend une pompe à chaleur, chauffe le liquide résiduaire produit par un procédé de fabrication de plaques pour générer de la vapeur d'eau dans une partie de libération de chaleur de la pompe à chaleur et refroidit la vapeur d'eau dans une partie d'absorption de chaleur de la pompe à chaleur.

7. Procédé de recyclage de liquide résiduaire produit par un procédé de fabrication de plaques selon l'une quelconque de la revendication 1 à la revendication 6, comprenant en outre la récupération de la matière concentrée provenant du liquide résiduaire produit par le procédé de fabrication de plaques, qui a été concentré par évaporation, dans une cuve de récupération par application d'une pression à l'aide d'une pompe.

8. Procédé de recyclage de liquide résiduaire produit par un procédé de fabrication de plaques selon l'une quelconque de la revendication 1 à la revendication 7, dans lequel le rapport de la quantité de liquide résiduaire produit par le procédé de fabrication de plaques après la concentration à la quantité de liquide résiduaire produit par le procédé de fabrication de plaques avant la concentration se situe dans une plage de 1/3 à 1/5 en termes de volume.

9. Procédé de recyclage de liquide résiduaire produit par un procédé de fabrication de plaques selon l'une quelconque de la revendication 1 à la revendication 8, dans lequel le rapport de la teneur du solvant organique ayant un point d'ébullition dans une plage de 100 °C à 300 °C au liquide de réapprovisionnement de développement se situe dans une plage de 5 % en masse à 20 % en masse.

10. Procédé de recyclage de liquide résiduaire produit par un procédé de fabrication de plaques selon l'une quelconque de la revendication 1 à la revendication 9, dans lequel le solvant organique ayant un point d'ébullition dans une plage de 100 °C à 300 °C comprend un solvant organique choisi dans le groupe constitué du 2-phényléthanol, du 3-phényl-1-propanol, du 2-phénoxyéthanol, de l'alcool benzylique, du cyclohexanol, de la monoéthanolamine, de la diéthanolamine, de la cyclohexanone, du lactate d'éthyle, du propylèneglycol, de l'éthylèneglycol, de la γ-butyrolactone, de la N-méthylpyrrolidone, de la N-éthylpyrrolidone, de l'éther monométhylique de propylène glycol, de l'éther monométhylique d'éthylèneglycol, de l'acétate d'éther monométhylique d'éthylèneglycol, de l'éther diméthylique de diéthylèneglycol et de la glycérine.

11. Procédé de recyclage de liquide résiduaire produit par un procédé de fabrication de plaques selon l'une quelconque de la revendication 1 à la revendication 10, dans lequel le solvant organique ayant un point d'ébullition dans une plage de 100 °C à 300 °C comprend un solvant organique choisi dans le groupe constitué de l'alcool benzylique, de la diéthanolamine, de la monoéthanolamine, de la γ-butyrolactone, de la N-méthylpyrrolidone et de la N-éthylpyrrolidone.

12. Procédé de recyclage de liquide résiduaire produit par un procédé de fabrication de plaques selon l'une quelconque de la revendication 1 à la revendication 11, comprenant en outre la réalisation d'une ou de plusieurs étapes choisies parmi (i) l'analyse des composants de l'eau régénérée et la neutralisation de l'eau régénérée d'après le résultat de l'analyse ou (ii) l'apport d'eau fraîche dans l'eau régénérée.

13. Procédé de recyclage de liquide résiduaire produit par un procédé de fabrication de plaques selon l'une quelconque de la revendication 1 à la revendication 12, dans lequel la plaque d'impression planographique photosensible est une plaque d'impression planographique négative.

14. Procédé de recyclage de liquide résiduaire produit par un procédé de fabrication de plaques selon la revendication 13, dans lequel le révélateur liquide pour la plaque d'impression planographique photosensible utilisée pour la plaque d'impression planographique négative est un révélateur liquide alcalin qui comprend un tensioactif et un hydroxyde de métal alcalin, mais qui ne comprend pas de composé de silicate, et qui a un pH dans une plage de 10 à 12,5.

15. Procédé de recyclage de liquide résiduaire produit par un procédé de fabrication de plaques selon l'une quelconque de la revendication 1 à la revendication 12, dans lequel la plaque d'impression planographique photosensible est une plaque d'impression planographique positive.

16. Procédé de recyclage de liquide résiduaire produit par un procédé de fabrication de plaques selon la revendication 15, dans lequel le révélateur liquide pour la plaque d'impression planographique photosensible utilisée pour la plaque d'impression planographique positive est un révélateur liquide alcalin qui comprend un composé organique ayant une action tampon et une base et qui ne comprend pas de composé de silicate.
